# EUROPEAN PATENT APPLICATION

(11) **EP 4 642 205 A1**
(43) Date of publication of application: **29.10.2025**
(21) Application number: 25170653.7
(22) Date of filing: 15.04.2025
(51) Int. Cl.: H10K 59/131, H10K 59/35, H10K 59/65

(54) **DISPLAY APPARATUS AND AN ELECTRONIC DEVICE INCLUDING THE SAME**

(30) Priority: 15.04.2024 KR 20240050207; 18.07.2024 KR 20240095159
(71) Applicant: Samsung Display Co., Ltd., Yongin-si, Gyeonggi-do 17113 (KR)
(72) Inventor: Nam, Donghun, Yongin-si, Gyeonggi-do 17113 (KR); Son, Donghyun, Yongin-si, Gyeonggi-do 17113 (KR); Kim, Eunhye, Yongin-si, Gyeonggi-do 17113 (KR); Lee, Sola, Yongin-si, Gyeonggi-do 17113 (KR)
(74) Representative: Gulde & Partner

(57) **Abstract**

A display apparatus includes: a substrate including a first area in which first sub-pixels are disposed and a second area in which basic units are disposed, the basic units including transmission areas and sub-pixel groups including second sub-pixels; first lines extending in a first direction and electrically connected to the first sub-pixels, the first lines each including a first sub-line and a second sub-line apart from each other with the second area therebetween; first connection lines disposed in the first area and each connecting the first sub-line and the second sub-line of each of the first lines to each other; and second lines extending in the first direction and electrically connected to the second sub-pixels.

## Description

### BACKGROUND

### 1. Field

One or more embodiments relate to a display apparatus.

### 2. Description of the Related Art

In general, a display apparatus includes a display element and electronic elements that control an electrical signal applied to the display element. The electronic elements include thin-film transistors, capacitors and lines.

Recently, the usage of display apparatuses has diversified. Also, as display apparatuses have become thinner and more lightweight, the range of use thereof has expanded. As the number of users increases, studies have been actively conducted to provide visual satisfaction to users, and one of them is to expand a display area of a display apparatus. Various studies have been attempted to expand the display area of the display apparatus.

### SUMMARY

One or more embodiments provide a display apparatus having a component area with improved light transmittance. However, this is only an example and the scope of the disclosure is not limited thereby.

Additional aspects will be set forth in part in the description which follows and, in part, will be apparent from the description, or may be learned by practice of the presented embodiments of the disclosure.

According to an aspect of the disclosure, a display apparatus includes: a substrate including a first area in which first sub-pixels are disposed and a second area in which basic units are disposed, the basic units including transmission areas and sub-pixel groups including second sub-pixels, first lines extending in a first direction and electrically connected to the first sub-pixels, the first lines each including a first sub-line and a second sub-line apart from each other with the second area therebetween, first connection lines disposed in the first area and each connecting the first sub-line and the second sub-line of each of the first lines to each other, and second lines extending in the first direction and electrically connected to the second sub-pixels.

In an embodiment, sub-pixel groups in each basic unit may be apart from each other.

In an embodiment, the sub-pixel groups and the transmission areas may be alternately disposed in a same row along a second direction perpendicular to the first direction.

In an embodiment, the second lines may be electrically connected to second sub-pixels included in sub-pixel groups of a first row in the second area and first sub-pixels disposed in a same column along the first direction as the second sub-pixels in the first row.

In an embodiment, the number of second lines passing through each basic unit among the second lines may be equal to the number of second sub-pixels included in one sub-pixel group.

In an embodiment, the second lines passing through each basic unit may be disposed sequentially.

In an embodiment, each basic unit may include a first sub-pixel group and a second sub-pixel group disposed in different rows, and each of the second lines passing through each basic unit may be electrically connected to a second sub-pixel included in the first sub-pixel group and a second sub-pixel included in the second sub-pixel group.

In an embodiment, at least a portion of each of the first connection lines may be disposed in a different layer from a corresponding first line among the first lines.

In an embodiment, each of the first connection lines may include a first portion extending in the first direction, a second portion connected to one end of the first portion and extending in a direction crossing the direction, and a third portion connected to another end of the first portion and extending in a direction crossing the first direction.

In an embodiment, the first portion of each of the first connection lines may be disposed on a same layer as the corresponding first line among the first lines, and the second portion and the third portion of each of the first connection lines may be disposed in a different layer from the corresponding first line and may be in contact with the corresponding first line through contact holes of at least one insulating layer.

In an embodiment, each of the first sub-pixels may include a transistor and a capacitor, the transistor may include a semiconductor layer, a gate electrode overlapping the semiconductor layer, and an electrode layer electrically connected to the semiconductor layer, and the capacitor may include the gate electrode as a lower electrode and an upper electrode disposed to overlap the lower electrode.

In an embodiment, the second portion and the third portion of each of the first connection lines may include a same material as a material of the electrode layer.

In an embodiment, each of the first sub-pixels may include a display element electrically connected to the transistor, the display element including a sub-pixel electrode, an opposite electrode, and an intermediate layer between the sub-pixel electrode and the opposite electrode, and the display apparatus may further include a contact metal layer having a lower portion connected to the electrode layer and an upper portion connected to the sub-pixel electrode.

In an embodiment, the first portion of each of the first connection lines may include a same material as a material of the contact metal layer.

In an embodiment, the first lines and the second lines may include data lines.

In an embodiment, the display apparatus may further include third lines extending in a second direction perpendicular to the first direction and electrically connected to the first sub-pixels, the third lines each including a first sub-line and a second sub-line apart from each other with the second area therebetween, and fourth lines extending in the second direction and electrically connected to the second sub-pixels.

In an embodiment, the display apparatus may further include second connection lines disposed in the first area and each connecting the first sub-line and the second sub-line included in each of some of the third lines to each other.

In an embodiment, the third lines and the fourth lines may include scan lines.

In an embodiment, the display apparatus may further include a component overlapping the second area.

In an embodiment, the component may include a camera or a sensor.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a plan view schematically illustrating a display apparatus according to an embodiment;
FIG. 2 is a schematic cross-sectional view of the display apparatus of FIG. 1 taken along line I-I' of FIG. 1, according to an embodiment;
FIG. 3A is a plan view schematically illustrating a display panel according to an embodiment;
FIG. 3B is a plan view illustrating a horizontal common voltage line and a vertical common voltage line of a display panel according to an embodiment;
FIGS. 4A and 4B are equivalent circuit diagrams of sub-pixels included in a display panel according to an embodiment;
FIG. 5 is a layout diagram schematically illustrating a sub-pixel disposition structure in a main display area according to an embodiment;
FIGS. 6A and 6B are layout diagrams schematically illustrating a sub-pixel disposition structure in a component area according to an embodiment;
FIG. 7 is a cross-sectional view schematically illustrating a sub-pixel circuit of a sub-pixel according to an embodiment;
FIG. 8 is a plan view schematically illustrating a portion of a display panel according to an embodiment;
FIGS. 9 and 10 are diagrams for describing the application of scan signals and data signals to a component area of a display panel according to an embodiment;
FIG. 11 is a plan view schematically illustrating a line disposition structure around a component area of a display panel according to an embodiment;
FIG. 12 is a cross-sectional view taken along line II-II' of FIG. 11 and illustrating data lines and first connection lines of a display panel according to an embodiment;
FIG. 13 is a cross-sectional view illustrating data lines and first connection lines of a display panel according to another embodiment;
FIG. 14 is a cross-sectional view illustrating data lines and first connection lines of a display panel according to still another embodiment;
FIG. 15 is a plan view schematically illustrating a portion of a display panel according to an embodiment;
FIG. 16 is a plan view schematically illustrating a line disposition structure around a component area of a display panel according to an embodiment;
FIG. 17 is a block diagram illustrating an electronic device according to an embodiment; and
FIG. 18 is a schematic diagrams illustrating electronic devices according to various embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings. When describing embodiments with reference to the accompanying drawings, the same or corresponding elements are denoted by the same reference numerals, and redundant descriptions thereof are omitted.

In the following embodiments, the terms "first," "second," etc. are not used in a restrictive sense and are used to distinguish one element from another.

The singular forms as used herein are intended to include the plural forms as well unless the context clearly indicates otherwise.

It will be further understood that the terms "include" and/or "comprise" as used herein specify the presence of stated features or elements, but do not preclude the presence or addition of one or more other features or elements.

It will be further understood that, when a layer, region, or element is referred to as being "on" another layer, region, or element, it may be directly on the other layer, region, or element, but also intervening layers, regions, or elements may be present therebetween.

Also, sizes of elements in the drawings may be exaggerated or reduced for convenience of explanation. For example, because sizes and thicknesses of elements in the drawings are arbitrarily illustrated for convenience of explanation, the disclosure is not necessarily limited thereto.

When a certain embodiment is implemented differently, a specific process sequence may be performed differently from a sequence described herein. For example, two consecutively described processes may be performed substantially at the same time or performed in an order opposite to the stated order.

It will be further understood that when layers, regions, or elements are referred to as being connected to each other, they may be directly connected to each other or indirectly connected to each other with intervening layers, regions, or elements therebetween. For example, when layers, regions, or elements are referred to as being electrically connected to each other, they may be directly electrically connected to each other or indirectly electrically connected to each other with intervening layers, regions, or elements therebetween.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

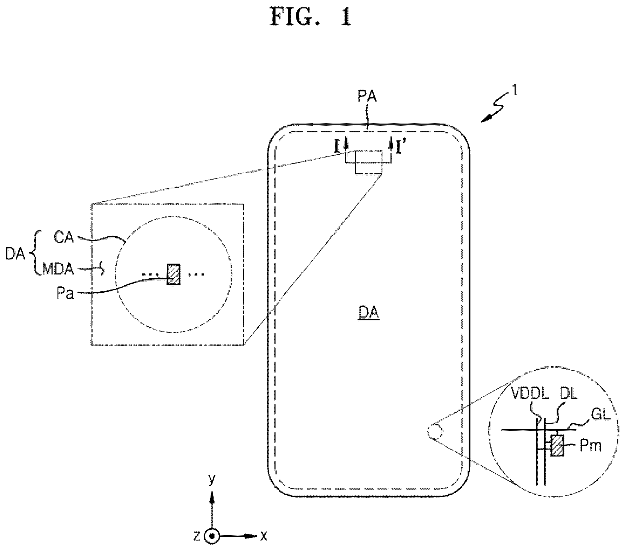

FIG. 1 is a plan view schematically illustrating a display apparatus 1 according to an embodiment. As used herein, the plan view is a view in a thickness direction (i.e., z direction) of the substrate 100.

Referring to FIG. 1, the display apparatus 1 may include a display area DA and a peripheral area PA outside the display area DA. The display area DA may be an area in which an image is displayed. The peripheral area PA may be a non-display area in which an image is not displayed.

In a plan view (or when viewed from a direction perpendicular to a substrate), the display area DA may have various shapes, such as a circular shape, an elliptical shape, or a polygonal shape. FIG. 1 illustrates that the display area DA has a substantially rectangular shape with round corners.

The display area DA may include a main display area MDA. The main display area MDA may occupy most of the area of the display area DA. The expression "occupying most of the area" may mean that the area of the main display area MDA is about 50 % or more of the area of the display area DA.

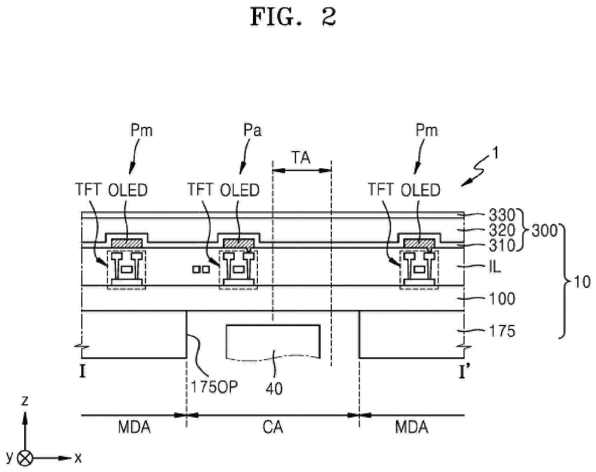

The display area DA may include a component area CA, which is an area in which a component (see 40 of FIG. 2) including an optical element and the like is disposed therebelow. The component area CA may be disposed inside the main display area MDA and may be at least partially surrounded by the main display area MDA. In an embodiment, the main display area MDA may be a first area and the component area CA may be a second area.

FIG. 1 illustrates that one component area CA is disposed inside the main display area MDA. In another embodiment, the number of component areas CA may be two or more. Although FIG. 1 illustrates that the component area CA has a substantially rectangular shape, the disclosure is not necessarily limited thereto. In a plan view (or when viewed from a direction perpendicular to a substrate), the component area CA may be changed to various shapes, for example, a circular shape, an elliptical shape, or a polygonal shape such as a rectangular shape.

The display apparatus 1 may display an image by using light emitted from sub-pixels disposed in the display area DA. Each of the sub-pixels may include a display element, such as an organic light-emitting diode. Each of the sub-pixels may emit, for example, red light, green light, or blue light.

In the present specification, among the sub-pixels disposed in the display area DA, sub-pixels disposed in the main display area MDA are referred to as first sub-pixels Pm and sub-pixels disposed in the component area CA are referred to as second sub-pixels Pa. The number of second sub-pixels Pa disposed in the component area CA may be less than the number of first sub-pixels Pm disposed in the main display area MDA. A resolution of an image displayed in the component area CA may be lower than a resolution of an image displayed in the main display area MDA.

Hereinafter, an organic light-emitting display apparatus is described as an example of the display apparatus 1 according to an embodiment, but the display apparatus 1 according to the disclosure is not limited thereto. In another embodiment, examples of the display apparatus 1 according to the disclosure may include an inorganic light-emitting display, a quantum dot light-emitting display, and the like. For example, an emission layer of a display element included in the display apparatus 1 may include an organic material, an inorganic material, or quantum dots, may include an organic material and quantum dots, or may include an inorganic material and quantum dots, but is not limited thereto.

FIG. 2 is a schematic cross-sectional view of the display apparatus 1 of FIG. 1 taken along line I-I' of FIG. 1, according to an embodiment.

Referring to FIG. 2, the display apparatus 1 may include a display panel 10 and a component 40 disposed below the display panel 10 and disposed to correspond to the component area CA. The display panel 10 may include a substrate 100, an insulating layer IL, a first sub-pixel Pm, a second sub-pixel Pa, an encapsulation layer 300, and a lower protective film 175.

The substrate 100 may include glass or polymer resin. The polymer resin may include polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 including the polymer resin may be flexible, rollable, or bendable. In an embodiment, the substrate 100 may have a multilayer structure including an inorganic layer and a layer including the polymer resin described above.

The first sub-pixel Pm including a transistor TFT and an organic light-emitting diode OLED electrically connected thereto as a display element may be disposed in the main display area MDA. The second sub-pixel Pa including a transistor TFT and an organic light-emitting diode OLED electrically connected thereto as a display element may be disposed in the component area CA. The insulating layer IL may be between components of the transistor TFT.

A transmission area TA in which transistors or display elements are not disposed may be disposed in the component area CA. The transmission area TA may be understood as an area through which light or sound output from the component 40 to the outside or light or sound traveling from the outside toward the component 40 is transmitted. In an embodiment, the light transmittance of the component area CA may be about 30 % or more, more specifically, about 50 % or more, about 75 % or more, about 80 % or more, about 85 % or more, or about 90 % or more.

The component 40 may be an electronic element using light or sound. Examples of the electronic element may include a sensor (e.g., a proximity sensor) configured to measure distance, a sensor configured to recognize a part of a user's body (e.g., a fingerprint, an iris, a face, etc.), an image sensor (e.g., a camera) configured to capture an image, or a small lamp configured to output light. The electronic element using light may use light of various wavelength bands, such as visible light, infrared light, or ultraviolet light. The electronic element using sound may use ultrasonic waves or sound of other frequency bands.

The encapsulation layer 300 may cover the organic light-emitting diode OLED. In an embodiment, the encapsulation layer 300 may include at least one inorganic encapsulation layer and at least one organic encapsulation layer. The encapsulation layer 300 may include a first inorganic encapsulation layer 310, a second inorganic encapsulation layer 330, and an organic encapsulation layer 320 therebetween. In another embodiment, the encapsulation layer 300 may be an encapsulation substrate, such as a glass material. A sealant including frit or the like may be between the substrate 100 and the encapsulation substrate.

Each of the first inorganic encapsulation layer 310 and the second inorganic encapsulation layer 330 may include at least one inorganic insulating material selected from aluminum oxide, titanium oxide, tantalum oxide, hafnium oxide, zinc oxide, silicon oxide, silicon nitride, and silicon oxynitride. The organic encapsulation layer 320 may include a polymer-based material. The polymer-based material may include acrylic-based resin, epoxy-based resin, polyimide, polyethylene, or the like.

The lower protective film 175 may be attached to a lower portion of the substrate 100 and may support and protect the substrate 100. The lower protective film 175 may define an opening 175OP corresponding to the component area CA. Due to the opening 175OP provided in the lower protective film 175, the light transmittance of the transmission area TA may be improved. The lower protective film 175 may include, for example, polyethylene terephthalate or polyimide.

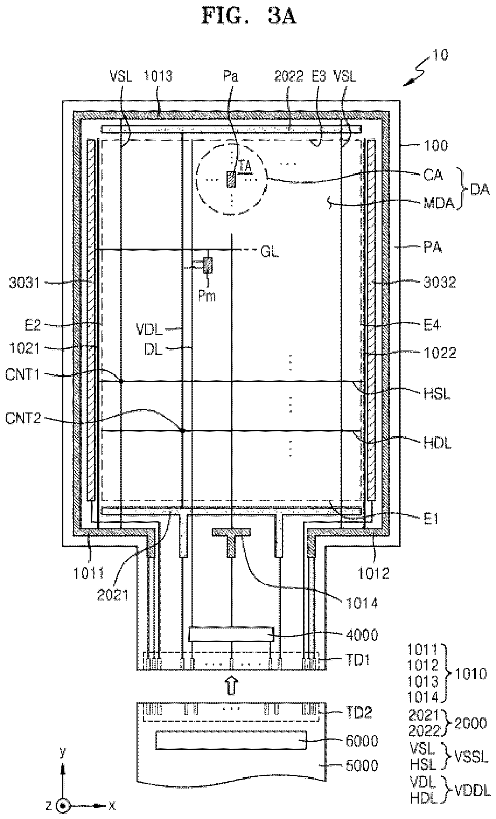

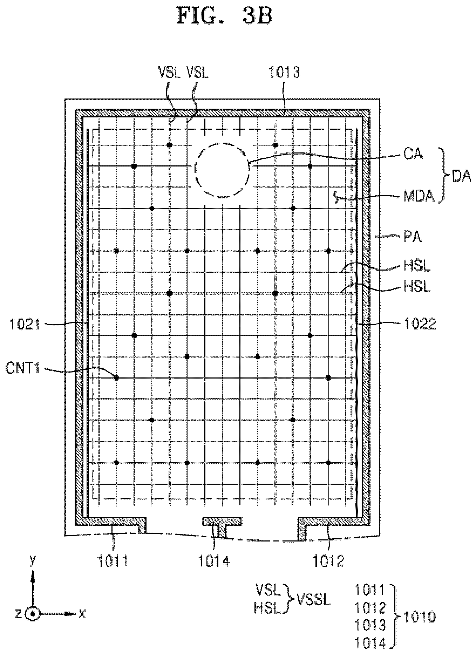

FIG. 3A is a plan view schematically illustrating a display panel according to an embodiment. FIG. 3B is a plan view illustrating a horizontal common voltage line and a vertical common voltage line of a display panel according to an embodiment.

Referring to FIG. 3A, sub-pixel circuits included in a first sub-pixel Pm and a second sub-pixel Pa may include transistors connected to signal lines or voltage lines configured to control turning on/off and luminance of display elements corresponding thereto. In this regard, FIG. 3A illustrates scan lines GL and data lines DL as the signal lines electrically connected to transistors and illustrates driving voltage lines VDDL and common voltage lines VSSL as the voltage lines.

The peripheral area PA may completely surround the display area DA. Voltage supply lines and driving circuits may be disposed in the peripheral area PA. In this regard, FIG. 3A illustrates that a common voltage supply line 1010, a driving voltage supply line 2000, a first driving circuit 3031, a second driving circuit 3032, and a data driving circuit 4000 are disposed in the peripheral area PA.

The common voltage supply line 1010 may have a loop shape that partially surrounds the display area DA and has one side open. The common voltage supply line 1010 may include a first common voltage input portion 1011, a second common voltage input portion 1012, and a third common voltage input portion 1014, which are disposed adjacent to a first edge E1 of the display area DA. In an embodiment, the first common voltage input portion 1011 and the second common voltage input portion 1012 may be disposed adjacent to the first edge E1 of the display area DA and apart from each other. The third common voltage input portion 1014 may be disposed adjacent to the first edge E1 of the display area DA between the first common voltage input portion 1011 and the second common voltage input portion 1012.

The first common voltage input portion 1011 and the second common voltage input portion 1012 may be connected to each other by a body portion 1013 extending along a second edge E2, a third edge E3, and a fourth edge E4 of the display area DA. In other words, the first common voltage input portion 1011, the second common voltage input portion 1012, and the body portion 1013 may be integrally formed as a single body. The common voltage supply line 1010 may have a loop shape with one side open. Two end portions of the common voltage supply line 1010 may correspond to the first common voltage input portion 1011 and the second common voltage input portion 1012, respectively. A portion between the first common voltage input portion 1011 and the second common voltage input portion 1012 may correspond to the body portion 1013.

A first auxiliary common voltage supply line 1021 and a second auxiliary common voltage supply line 1022 may be disposed in the peripheral area PA. Each of the first auxiliary common voltage supply line 1021 and the second auxiliary common voltage supply line 1022 may be a type of branch line extending from the common voltage supply line 1010.

The first auxiliary common voltage supply line 1021 may be electrically connected to the common voltage supply line 1010 and may extend along the second edge E2 of the display area DA. The first auxiliary common voltage supply line 1021 may be between the first driving circuit 3031 and the second edge E2 of the display area DA.

The second auxiliary common voltage supply line 1022 may be electrically connected to the common voltage supply line 1010 and may extend along the fourth edge E4 of the display area DA. The second auxiliary common voltage supply line 1022 may be between the second driving circuit 3032 and the fourth edge E4 of the display area DA. The common voltage supply line 1010, the first auxiliary common voltage supply line 1021, and the second auxiliary common voltage supply line 1022 may be electrically connected to the common voltage lines VSSL passing through the display area DA. The common voltage line VSSL may be electrically connected to an opposite electrode (e.g., a cathode) of the display element.

The common voltage lines VSSL may include a first common voltage line and a second common voltage line, which extend across each other. For example, the common voltage lines VSSL may include the first common voltage line extending in the y direction and the second common voltage line extending in the x direction. For convenience of explanation, the "first common voltage line extending in the y direction" is referred to as a vertical common voltage line VSL and the "second common voltage line extending in the x direction" is referred to as a horizontal common voltage line HSL.

The vertical common voltage line VSL and the horizontal common voltage line HSL may pass through the display area DA so as to cross each other. For example, as illustrated in FIG. 3B, vertical common voltage lines VSL and horizontal common voltage lines HSL, which cross each other, may have a mesh structure in a plan view. When the display area DA includes the component area CA including the transmission area TA, the vertical common voltage line VSL and the horizontal common voltage line HSL may be disposed not to pass through the component area CA so as to sufficiently ensure the transmission area TA.

The vertical common voltage line VSL may be electrically connected to the common voltage supply line 1010. Some of the vertical common voltage lines VSL may be electrically connected to the first common voltage input portion 1011 and the body portion 1013, others thereof may be electrically connected to the second common voltage input portion 1012 and the body portion 1013, and others thereof may be electrically connected to the third common voltage input portion 1014 and the body portion 1013.

The horizontal common voltage line HSL may be electrically connected to the first auxiliary common voltage supply line 1021 and the second auxiliary common voltage supply line 1022. One end portion of each of the horizontal common voltage lines HSL may be electrically connected to the first auxiliary common voltage supply line 1021, and the other end portion of each of the horizontal common voltage lines HSL may be electrically connected to the second auxiliary common voltage supply line 1022.

The vertical common voltage line VSL and the horizontal common voltage line HSL may be disposed on different layers. In some embodiments, the vertical common voltage line VSL and the horizontal common voltage line HSL may be electrically connected to each other through a first contact hole CNT1 defined in at least one insulating layer therebetween. The first contact hole CNT1 for connection of the vertical common voltage line VSL and the horizontal common voltage line HSL may be located in the display area DA.

The driving voltage supply line 2000 may include a first driving voltage input portion 2021 and a second driving voltage input portion 2022, which are apart from each other with the display area DA therebetween. The first driving voltage input portion 2021 and the second driving voltage input portion 2022 may extend substantially parallel to each other with the display area DA therebetween. The first driving voltage input portion 2021 may be disposed adjacent to the first edge E1 of the display area DA and the second driving voltage input portion 2022 may be disposed adjacent to the third edge E3 of the display area DA.

The driving voltage supply line 2000 may be electrically connected to the driving voltage lines VDDL passing through the display area DA. The driving voltage line VDDL may include a first driving voltage line and a second driving voltage line, which extend across each other. For example, the driving voltage line VDDL may include the first driving voltage line extending in the y direction and the second driving voltage line extending in the x direction. For convenience of explanation, the "first driving voltage line extending in the y direction" is referred to as a vertical driving voltage line VDL and the "second driving voltage line extending in the x direction" is referred to as a horizontal driving voltage line HDL.

The vertical driving voltage line VDL and the horizontal driving voltage line HDL may pass through the display area DA so as to cross each other. The vertical driving voltage line VDL and the horizontal driving voltage line HDL may be disposed on different layers and may be connected to each other through a second contact hole CNT2 defined in at least one insulating layer therebetween. The second contact hole CNT2 for connection of the vertical driving voltage line VDL and the horizontal driving voltage line HDL may be located in the display area DA.

The first driving circuit 3031 and the second driving circuit 3032 may be disposed in the peripheral area PA. The scan line GL may be electrically connected to the first driving circuit 3031 and/or the second driving circuit 3032. In some embodiments, some of the scan lines GL may be electrically connected to the first driving circuit 3031 and the remaining scan lines GL may be connected to the second driving circuit 3032. Each of the first driving circuit 3031 and the second driving circuit 3032 may include a scan driver configured to generate a scan signal. The scan signal generated by the scan driver may be transmitted to any one transistor of the sub-pixel circuit through the scan line GL.

The data driving circuit 4000 may be configured to transmit a data signal to any one transistor included in each of the sub-pixel circuits through the data line DL passing through the display area DA.

A first terminal portion TD1 may be disposed on one side of the substrate 100. A printed circuit board 5000 may be attached to the first terminal portion TD1. The printed circuit board 5000 may include a second terminal portion TD2 electrically connected to the first terminal portion TD1, and a controller 6000 may be disposed on the printed circuit board 5000. Control signals of the controller 6000 may be provided to the first and second driving circuits 3031 and 3032, the data driving circuit 4000, the driving voltage supply line 2000, and the common voltage supply line 1010 through the first and second terminal portions TD1 and TD2.

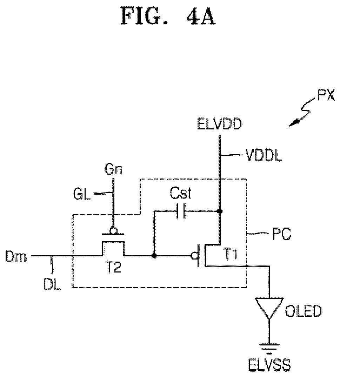

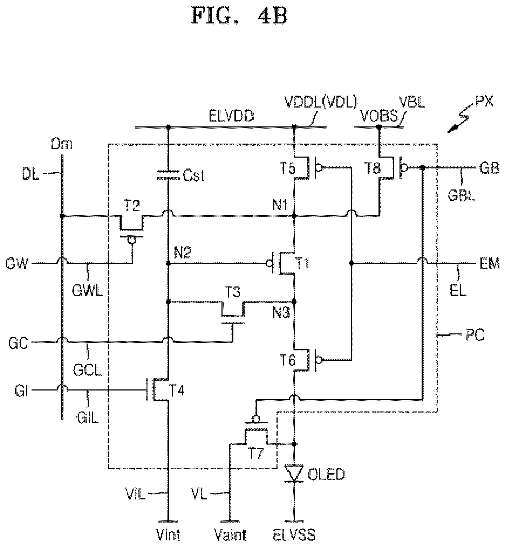

FIGS. 4A and 4B are equivalent circuit diagrams schematically illustrating a sub-pixel circuit included in a sub-pixel of a display panel according to an embodiment. Sub-pixels PX of FIGS. 4A and 4B may be the first sub-pixel Pm and/or the second sub-pixel Pa. Each of the sub-pixels PX may include a sub-pixel circuit PC and an organic light-emitting diode OLED connected to the sub-pixel circuit PC as a display element.

Referring to FIG. 4A, in an embodiment, the sub-pixel circuit PC may include a first transistor T1, a second transistor T2, and a capacitor Cst. The sub-pixel circuit PC may be electrically connected to a scan line GL and a data line DL. The first transistor T1 may be a driving transistor and the second transistor T2 may be a switching transistor. The second transistor T2 may be electrically connected to the scan line GL and the data line DL and may be configured to transmit, to the first transistor T1, a data signal Dm input through the data line DL in response to a scan signal Gn input through the scan line GL.

The capacitor Cst may be connected to the second transistor T2 and a driving voltage line VDDL and may be configured to store a voltage corresponding to the difference between a voltage received from the second transistor T2 and a driving voltage ELVDD supplied to the driving voltage line VDDL.

The first transistor T1 may be connected to the driving voltage line VDDL and the capacitor Cst and may be configured to control a driving current flowing from the driving voltage line VDDL to the organic light-emitting diode OLED according to a voltage value stored in the capacitor Cst. The organic light-emitting diode OLED may be configured to emit light with a certain luminance according to the driving current.

A case where the sub-pixel circuit PC includes two transistors and one capacitor is illustrated as an embodiment, but the disclosure is not necessarily limited thereto. In another embodiment, the sub-pixel circuit PC may include three or more transistors and/or two or more capacitors.

Referring to FIG. 4B, in an embodiment, the sub-pixel circuit PC may include first to eighth transistors T1, T2, T3, T4, T5, T6, T7, and T8 and a capacitor Cst. The sub-pixel circuit PC may be electrically connected to a data line DL, a first gate line GWL, a second gate line GIL, a third gate line GCL, a fourth gate line GBL, and an emission control line EL. In addition, the sub-pixel circuit PC may be electrically connected to an initialization voltage line VL, a node initialization voltage line VIL, and a driving voltage line VDDL.

In an embodiment, some of the first to eighth transistors T1 to T8 may each be provided as an n-channel metal-oxide semiconductor field effect transistor ("MOSFET") ("NMOS"), and the others thereof may each be a p-channel MOSFET ("PMOS"). FIG. 4B illustrates that the third transistor T3 and the fourth transistor T4 among the first to eighth transistors T1 to T8 are each provided as an NMOS, and the others are each provided as a PMOS. However, the disclosure is not necessarily limited thereto. In another embodiment, all of the first to eighth transistors T1 to T8 may each be provided as a PMOS or an NMOS. Depending on the type of transistor and/or operating conditions, a first terminal of the transistor may be a source electrode or a drain electrode and a second terminal may be an electrode that is different from the first terminal. For example, when the first terminal is a source electrode, the second terminal may be a drain electrode.

The first transistor T1 may be connected between a driving voltage line VDDL and an organic light-emitting diode OLED. The first transistor T1 may be connected between a first node N1 and a third node N3. The first transistor T1 may be electrically connected to the driving voltage line VDDL via the fifth transistor T5 and may be electrically connected to the organic light-emitting diode OLED via the sixth transistor T6. The first transistor T1 may include a gate electrode connected to a second node N2, a first terminal connected to the first node N1, and a second terminal connected to the third node N3. The driving voltage line VDDL may be configured to transmit a driving voltage ELVDD to the first transistor T1. The first transistor T1, which is a driving transistor, may be configured to receive a data signal Dm according to the switching operation of the second transistor T2 and supply a driving current to the organic light-emitting diode OLED.

The second transistor T2 (data write transistor) may be connected between the data line DL and the first node N1. The second transistor T2 may be electrically connected to the driving voltage line VDDL via the fifth transistor T5. The second transistor T2 may include a gate electrode connected to the first gate line GWL, a first terminal connected to the data line DL, and a second terminal connected to the first node N1. The second transistor T2 may be configured to be turned on in response to a first scan signal GW received through the first gate line GWL and perform a switching operation to transmit, to the first node N1, the data signal Dm transmitted through the data line DL.

The third transistor T3 (compensation transistor) may be connected between the second node N2 and the third node N3. The third transistor T3 may be electrically connected to the organic light-emitting diode OLED via the sixth transistor T6. The third transistor T3 may include a gate electrode connected to a third gate line GCL, a first terminal connected to the second node N2, and a second terminal connected to the third node N3. The third transistor T3 may be configured to be turned on in response to a third scan signal GC received through the third gate line GCL and compensate for a threshold voltage of the first transistor T1 by diode-connecting the first transistor T1.

The fourth transistor T4 (node initialization transistor) may be connected between the second node N2 and the node initialization voltage line VIL. The fourth transistor T4 may include a gate electrode connected to the second gate line GIL, a first terminal connected to the second node N2, and a second terminal connected to the node initialization voltage line VIL. The fourth transistor T4 may be configured to be turned on in response to a second scan signal GI received through the second gate line GIL and initialize the gate electrode of the first transistor T1 by transmitting an initialization voltage Vint to the gate electrode of the first transistor T1.

The fifth transistor T5 (first emission control transistor) may be connected between the driving voltage line VDDL and the first node N1. The fifth transistor T5 may include a gate electrode connected to the emission control line EL, a first terminal connected to the driving voltage line VDDL, and a second terminal connected to the first node N1.

The sixth transistor T6 (second emission control transistor) may be connected between the organic light-emitting diode OLED and the third node N3. The sixth transistor T6 may include a gate electrode connected to the emission control line EL, a first terminal connected to the third node N3, and a second terminal connected to a sub-pixel electrode of the organic light-emitting diode OLED. The fifth transistor T5 and the sixth transistor T6 may be configured to be simultaneously turned on in response to an emission control signal EM received through the emission control line EL so that the driving current flows to the organic light-emitting diode OLED.

The seventh transistor T7 (initialization transistor) may be connected between the organic light-emitting diode OLED and the initialization voltage line VL. The seventh transistor T7 may include a gate electrode connected to the fourth gate line GBL, a first terminal connected to the second terminal of the sixth transistor T6 and the sub-pixel electrode of the organic light-emitting diode OLED, and a second terminal connected to the initialization voltage line VL. The seventh transistor T7 may be configured to be turned on in response to a fourth scan signal GB received through the fourth gate line GBL and initialize the sub-pixel electrode of the organic light-emitting diode OLED by transmitting an initialization voltage Vaint to the sub-pixel electrode of the organic light-emitting diode OLED. The seventh transistor T7 may be configured to be turned on simultaneously with the eighth transistor T8 in response to the fourth scan signal GB. In some embodiments, the seventh transistor T7 may include two seventh transistors connected in series.

The eighth transistor T8 (bias transistor) may be connected between the first node N1 and a bias voltage line VBL. The eighth transistor T8 may include a gate electrode connected to the fourth gate line GBL, a first terminal connected to the bias voltage line VBL, and a second terminal connected to the first node N1. The eighth transistor T8 may be configured to be turned on in response to the fourth scan signal GB received through the fourth gate line GBL and apply a bias voltage VOBS to the first terminal of the first transistor T1 so as to preset a voltage suitable for the subsequent operation of the first transistor T1 at the first terminal.

The capacitor Cst may include a lower electrode connected to the gate electrode of the first transistor T1 and an upper electrode connected to the driving voltage line VDDL. The capacitor Cst may store and maintain a voltage corresponding to a voltage difference between the driving voltage line VDDL and the gate electrode of the first transistor T1, and thus, the voltage applied to the gate electrode of the first transistor T1 may be maintained.

The organic light-emitting diode OLED may include the sub-pixel electrode and an opposite electrode, and the opposite electrode may be configured to receive a common voltage ELVSS. The organic light-emitting diode OLED may be configured to receive the driving current from the first transistor T1, emit light, and display an image.

Although FIG. 4B illustrates a case where the sub-pixel circuit PC includes eight transistors and one capacitor, the disclosure is not necessarily limited thereto. The number of transistors and capacitors included in the sub-pixel circuit PC and the circuit design may be variously modified.

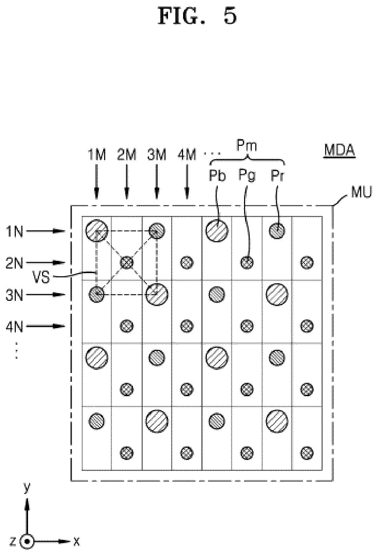

FIG. 5 is a layout diagram schematically illustrating a sub-pixel disposition structure in a main display area MDA according to an embodiment.

Referring to FIG. 5, first sub-pixels Pm may be disposed in the main display area MDA. Each of the first sub-pixels Pm may include a display element, such as an organic light-emitting diode. Each of the first sub-pixels Pm disposed in the main display area MDA may include a first red sub-pixel Pr, a first green sub-pixel Pg, and a first blue sub-pixel Pb. The first red sub-pixel Pr, the first green sub-pixel Pg, and the first blue sub-pixel Pb may implement red color, green color, and blue color, respectively.

In an embodiment, the first sub-pixels Pm may be disposed in a PenTile structure. In the PenTile structure, each of the first sub-pixels Pm may include one red sub-pixel Pr, two green sub-pixels Pg, and one blue sub-pixel Pb so as to be a unit pixel, which is repeatedly disposed in x direction and y direction. In an embodiment, it may be stated that the first blue sub-pixels Pb are disposed at first and third vertices facing each other among vertices of a virtual square VS with the center point of the first green sub-pixel Pg as the center point of the square, and the first red sub-pixels Pr are disposed at the remaining vertices, that is, second and fourth vertices of the virtual square VS as shown in FIG. 5. In another embodiment, the virtual square VS may be modified into various shapes, for example, a rectangular shape, a rhombus shape, or a square shape. The size of the first green sub-pixel Pg may be smaller than the size of each of the first red sub-pixel Pr and the first blue sub-pixel Pb.

In a first row 1N, the first blue sub-pixels Pb and the first red sub-pixels Pr may be alternately disposed. In a second row 2N, the first green sub-pixels Pg may be repeatedly disposed. In a third row 3N, the first red sub-pixels Pr and the first blue sub-pixels Pb may be alternately disposed. In a fourth row 4N, the first green sub-pixels Pg may be repeatedly disposed. The first to fourth rows 1N to 4N described above may be repeatedly disposed along the y direction.

The first blue sub-pixels Pb and the first red sub-pixels Pr of the first row 1N and the first green sub-pixels Pg of the second row 2N may be alternately disposed. In a first column 1M, the first blue sub-pixels Pb and the first red sub-pixels Pr may be alternately disposed. In a second column 2M, the first green sub-pixels Pg may be repeatedly disposed. In a third column 3M, the first red sub-pixels Pr and the first blue sub-pixels Pb may be alternately disposed. In a fourth column 4M, the first green sub-pixels Pg may be repeatedly disposed. The first to fourth columns 1M to 4M described above may be repeatedly disposed along the x direction.

Such a pixel disposition structure is referred to as a PenTile matrix structure or a PenTile structure. High resolution may be implemented with a small number of pixels by applying a rendering operation that expresses colors while sharing adjacent pixels.

Although FIG. 5 illustrates that the first sub-pixels Pm are disposed in a PenTile structure, the disclosure is not necessarily limited thereto. For another example, the first sub-pixels Pm may be disposed in other shapes, for example, a stripe structure, a mosaic disposition structure, or a delta disposition structure.

The disposition of the first sub-pixels Pm illustrated in FIG. 5 may correspond to the disposition of the organic light-emitting diodes, which are the display elements. For example, the position of the first red sub-pixel Pr illustrated in FIG. 5 may correspond to the position of the display element that emits red light. Similarly, the position of the first green sub-pixel Pg may correspond to the position of the display element that emits green light, and the position of the first blue sub-pixel Pb may correspond to the position of the display element that emits blue light.

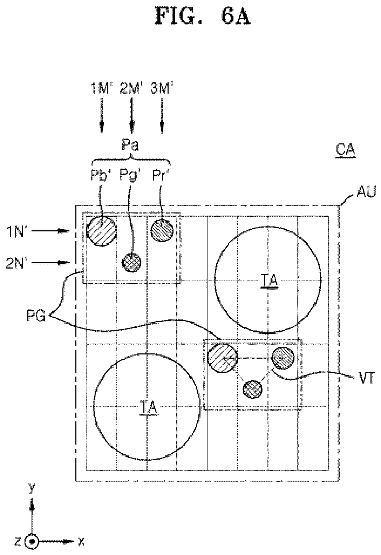

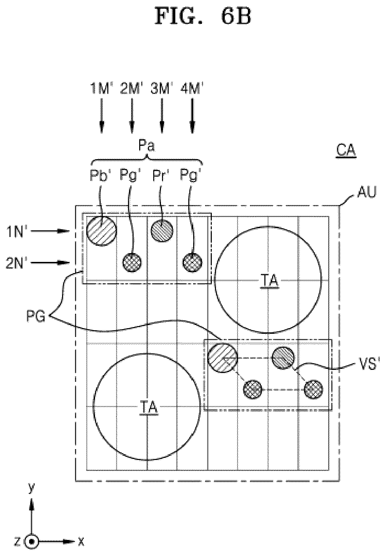

FIGS. 6A and 6B are layout diagrams schematically illustrating a sub-pixel disposition structure in a component area according to an embodiment.

Referring to FIGS. 6A and 6B, each of the second sub-pixels Pa disposed in the component area CA may include a second red sub-pixel Pr', a second green sub-pixel Pg', and a second blue sub-pixel Pb'. The second red sub-pixel Pr', the second green sub-pixel Pg', and the second blue sub-pixel Pb' may implement red, green, and blue colors, respectively. Each of the second sub-pixels Pa may include a display element, such as an organic light-emitting diode. In an embodiment, the size, shape, and/or disposition structure of the second sub-pixels Pa of the component area CA may be different from the size, shape, and/or disposition structure of the first sub-pixels Pm of the main display area MDA.

The component area CA may include a transmission area TA and a sub-pixel group PG including the second sub-pixels Pa. Each of the sub-pixel group PG and the transmission area TA may be provided in plurality. The sub-pixel group PG may be defined as an array of sub-pixels in which the second sub-pixels Pa are grouped into preset units. The preset unit, the sub-pixel group PG, may include a second red sub-pixel Pr', a second green sub-pixel Pg', and a second blue sub-pixel Pb', which emit light of different colors from each other. In the component area CA, the sub-pixel groups PG may be apart from each other.

Referring to FIG. 6A, one sub-pixel group PG may include three second sub-pixels Pa, that is, one second blue sub-pixel Pb', one second red sub-pixel Pr', and one second green sub-pixel Pg'. The second sub-pixels Pa included in one sub-pixel group PG may be disposed in a structure of two rows along the y direction and three columns along the x direction within the sub-pixel group PG. In a first row 1N', the second blue sub-pixels Pb' and the second red sub-pixels Pr' may be alternately disposed. In a second row 2N', the second green sub-pixel Pg' may be disposed. In a first column 1M', the second blue sub-pixel Pb' may be disposed. In a second column 2M', the second green sub-pixel Pg' may be disposed. In a third column 3M', the second red sub-pixel Pr' may be disposed. For example, it may be stated that the second blue sub-pixel Pb', the second red sub-pixel Pr', and the second green sub-pixel Pg' are disposed at vertices of a virtual triangle VT, respectively, as shown in FIG. 6A.

Referring to FIG. 6B, one sub-pixel group PG may include fourth second sub-pixels Pa, that is, one second blue sub-pixel Pb', one second red sub-pixel Pr', and two second green sub-pixels Pg'. The second sub-pixels Pa included in one sub-pixel group PG may be disposed based on a PenTile structure. The second sub-pixels Pa included in one sub-pixel group PG may be disposed in a structure of two rows along the y direction and four columns along the x direction within the sub-pixel group PG. In a first row 1N', the second blue sub-pixels Pb' and the second red sub-pixels Pr' may be alternately disposed. In a second row 2N', the second green sub-pixels Pg' may be disposed. In a first column 1M', the second blue sub-pixel Pb' may be disposed. In a second column 2M', the second green sub-pixel Pg' may be disposed. In a third column 3M', the second red sub-pixel Pr' may be disposed. In a fourth column 4M', the second green sub-pixel Pg' may be disposed. For example, the four second sub-pixels Pa may have a pixel disposition structure in which the second sub-pixels Pa are disposed at corners of a virtual square VS', respectively, as shown in FIG. 6B. The virtual square VS' may be a parallelogram.

The transmission area TA may be disposed on one side of the sub-pixel group PG. The transmission areas TA may be disposed adjacent to the sub-pixel groups PG. Sub-pixels may not be disposed in the transmission area TA. This may mean that a sub-pixel electrode, an intermediate layer, an opposite electrode, which constitute the display element, and a sub-pixel circuit electrically connected thereto are not disposed in the transmission area TA. In an embodiment, some of the signal lines connected to supply signals to the second sub-pixels Pa located in the component area CA may be disposed across the transmission area TA. However, even in this case, in order to increase the light transmittance of the transmission area TA, the signal lines may be disposed to bypass the central portion of the transmission area TA so as to be biased toward one side. FIGS. 6A and 6B illustrate that the transmission area TA is provided in a circular shape, but the disclosure is not necessarily limited thereto, and the transmission area TA may be provided in other shapes, for example, a polygonal shape, an octagonal shape, or an elliptical shape.

The sub-pixel groups PG and the transmission areas TA disposed in the component area CA may be alternately disposed along one direction. The sub-pixel groups PG and the transmission areas TA disposed in the component area CA may be alternately disposed in the same column along the x direction (e.g., the row direction). In an embodiment, the sub-pixel groups PG and the transmission areas TA disposed in the component area CA may be alternately disposed in the same row or column along the x direction (e.g., the row direction) and the y direction (e.g., the column direction). The transmission area TA may be disposed between the sub-pixel groups PG, and the transmission area TA may surround at least a portion of the sub-pixel group PG.

In the component area CA, basic units AU each including a certain number of sub-pixel groups PG and a certain number of transmission areas TA may be repeatedly disposed in the x direction and the y direction. The basic unit AU is a segment of a repetitive shape and does not mean any disconnection in the configuration.

The basic unit AU may contain at least one sub-pixel group PG. In an embodiment, the basic unit AU may include sub-pixel groups PG. The sub-pixel groups PG may be apart from each other within the basic unit AU. The sub-pixel groups PG may be disposed in multiple rows and/or columns within the basic unit AU. FIG. 6A illustrates that the basic unit AU includes two sub-pixel groups PG and two transmission areas TA disposed therearound, and the two sub-pixel groups PG and the two transmission areas TA included in the basic unit AU are alternately disposed along the row direction (e.g., the x direction) and the column direction (e.g., the y direction). FIG. 6B illustrates that the basic unit AU includes two sub-pixel groups PG and two transmission areas TA, and the two sub-pixel groups PG and the two transmission areas TA included in the basic unit AU are alternately disposed in the row direction (e.g., the x direction) and the column direction (e.g., the y direction). However, the disclosure is not necessarily limited thereto, and the sub-pixel group PG and the transmission area TA may be variously disposed within the basic unit AU.

A corresponding unit (see MU of FIG. 5) having the same area as the area of the basic unit AU may be set in the main display area MDA. The number of first sub-pixels Pm included in the corresponding unit MU may be greater than the number of second sub-pixels Pa included in the basic unit AU. For example, FIG. 6A illustrates that the number of second sub-pixels Pa included in the basic unit AU is 6 and the number of first sub-pixels Pm included in the corresponding unit MU is 32. FIG. 6B illustrates that the number of second sub-pixels Pa included in the basic unit AU is 8 and the number of first sub-pixels Pm included in the corresponding unit MU is 32.

The pixel disposition structures illustrated in FIGS. 6A and 6B are only embodiments, and the disclosure is not necessarily limited thereto. The disposition structure and number of second sub-pixels Pa included in the basic unit AU may be designed differently according to the resolution of the component area CA.

The disposition of the second sub-pixels Pa illustrated in FIGS. 6A and 6B may correspond to the disposition of the organic light-emitting diodes, which are the display elements. For example, the position of the second red sub-pixel Pr' illustrated in FIGS. 6A and 6B may correspond to the position of the display element that emits red light, the position of the second green sub-pixel Pg' may correspond to the position of the display element that emits green light, and the position of the second blue sub-pixel Pb' may correspond to the position of the display element that emits blue light. Each of the sub-pixel groups PG illustrated in FIGS. 6A and 6B may correspond to a display element group including the display element that emits red light, the display element that emits green light, and the display element that emits blue light.

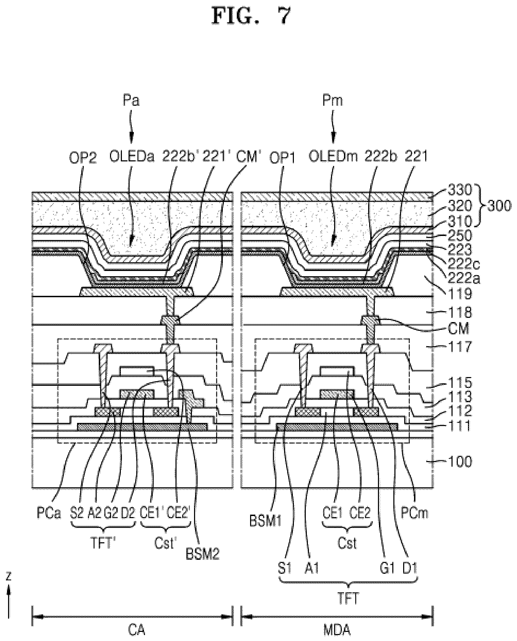

FIG. 7 is a cross-sectional view schematically illustrating a sub-pixel circuit of a sub-pixel according to an embodiment.

Referring to FIG. 7, a first sub-pixel Pm may be disposed in a main display area MDA and a second sub-pixel Pa may be disposed in a component area CA. The first sub-pixel Pm may include a display element disposed in the main display area MDA and a sub-pixel circuit connected thereto. The second sub-pixel Pa may include a display element disposed in the component area CA and a sub-pixel circuit electrically connected thereto. The display element may be an organic light-emitting diode. The sub-pixel circuit may include transistors and at least one capacitor.

For convenience of explanation, an organic light-emitting diode disposed in the main display area MDA is referred to as a first organic light-emitting diode OLEDm and an organic light-emitting diode disposed in the component area CA is referred to as a second organic light-emitting diode OLEDa. In addition, a sub-pixel circuit disposed in the main display area MDA is referred to as a first sub-pixel circuit PCm and a sub-pixel circuit disposed in the component area CA is referred to as a second sub-pixel circuit PCa. FIG. 7 illustrates a transistor TFT and a capacitor Cst included in a first sub-pixel circuit PCm and a transistor TFT' and a capacitor Cst' included in a second sub-pixel circuit PCa.

A first metal layer BSM1 may be disposed below the transistor TFT of the first sub-pixel Pm to overlap the transistor TFT in a plan view. The first metal layer BSM1 may prevent characteristics of the transistor TFT from deteriorating. A second metal layer BSM2 may be disposed below the transistor TFT' of the second sub-pixel Pa to overlap the transistor TFT' in a plan view. The second metal layer BSM2 may prevent characteristics of the transistor TFT' from deteriorating. In some embodiments, the first metal layer BSM1 disposed to overlap the transistor TFT may be omitted.

The first and second metal layers BSM1 and BSM2 may each include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu). The first and second metal layers BSM1 and BSM2 may each be a single layer or layers including the material described above.

The transistor TFT and the transistor TFT' may be disposed on an upper portion of a buffer layer 111. The transistor TFT may include a first semiconductor layer A1, a first gate electrode G1, a first source electrode S1, and a first drain electrode D1, and the transistor TFT' may include a second semiconductor layer A2, a second gate electrode G2, a second source electrode S2, and a second drain electrode D2.

The first semiconductor layer A1 and the second semiconductor layer A2 may be disposed on the buffer layer 111 and may each include polysilicon. In another embodiment, the first semiconductor layer A1 and the second semiconductor layer A2 may each include amorphous silicon. In another embodiment, the first semiconductor layer A1 and the second semiconductor layer A2 may each include an oxide of at least one selected from indium (In), gallium (Ga), stannum (Sn), zirconium (Zr), vanadium (V), hafnium (Hf), cadmium (Cd), germanium (Ge), chromium (Cr), titanium (Ti), and zinc (Zn). The first semiconductor layer A1 and the second semiconductor layer A2 may each include a channel region, and a source region and a drain region doped with impurities.

A first gate insulating layer 112 may be disposed to cover the first semiconductor layer A1 and the second semiconductor layer A2. The first gate insulating layer 112 may include an inorganic insulating material, such as silicon oxide, silicon nitride, silicon oxynitride, aluminum oxide, titanium oxide, tantalum oxide, hafnium oxide, or zinc oxide. The first gate insulating layer 112 may include a single layer or layers including the inorganic insulating material described above.

The first and second gate electrodes G1 and G2 may be disposed on the first gate insulating layer 112 to overlap the first and second semiconductor layers A1 and A2, respectively in a plan view. The first and second gate electrodes G1 and G2 may each include molybdenum (Mo), aluminum (Al), copper (Cu), titanium (Ti), or the like and may include a single layer or layers. For example, the first and second gate electrodes G1 and G2 may each be a single layer including molybdenum (Mo).

The second gate insulating layer 113 may be disposed to cover the first and second gate electrodes G1 and G2. The second gate insulating layer 113 may include an inorganic insulating material, such as silicon oxide, silicon nitride, silicon oxynitride, aluminum oxide, titanium oxide, tantalum oxide, hafnium oxide, or zinc oxide. The second gate insulating layer 113 may include a single layer or layers including the inorganic insulating material described above.

A first upper electrode CE2 of the capacitor Cst and a second upper electrode CE2' of the capacitor Cst' may be disposed on the second gate insulating layer 113. In the main display area MDA, the first upper electrode CE2 may overlap the first gate electrode G1 therebelow in a plan view. The first gate electrode G1 and the first upper electrode CE2 overlapping each other in a plan view with the second gate insulating layer 113 therebetween may constitute the capacitor Cst. The first gate electrode G1 may be a first lower electrode CE1 of the capacitor Cst.

In the component area CA, the second upper electrode CE2' may overlap the second gate electrode G2 therebelow in a plan view. The second gate electrode G2 and the second upper electrode CE2' overlapping each other with the second gate insulating layer 113 therebetween in a plan view may constitute the capacitor Cst'. The second gate electrode G2 may be a second lower electrode CE1' of the capacitor Cst'.

The first and second upper electrodes CE2 and CE2' may each include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu), and may include a single layer or layers including the material described above.

An interlayer-insulating layer 115 may be disposed to cover the first and second upper electrodes CE2 and CE2'. The interlayer-insulating layer 115 may include an inorganic insulating material, such as silicon oxide, silicon nitride, silicon oxynitride, aluminum oxide, titanium oxide, tantalum oxide, hafnium oxide, or zinc oxide.

The first and second source electrodes S1 and S2 and the first and second drain electrodes D1 and D2 may be disposed on the interlayer-insulating layer 115. The first and second source electrodes S1 and S2 and the first and second drain electrodes D1 and D2 may each include a conductive material including molybdenum (Mo), aluminum (Al), copper (Cu), titanium (Ti), and the like, and may include a single layer or layers including the conductive material described above. For example, the first and second source electrodes S1 and S2 and the first and second drain electrodes D1 and D2 may each have a multilayer structure of Ti/Al/Ti.

A first planarization layer 117 may be disposed to cover the first and second source electrodes S1 and S2 and the first and second drain electrodes D1 and D2. The first planarization layer 117 may have a flat upper surface so that first and second sub-pixel electrodes 221 and 221' disposed thereon may be formed to be flat.

A second planarization layer 118 may be disposed on the first planarization layer 117. Contact metal layers CM and CM' may be between the first planarization layer 117 and the second planarization layer 118. The contact metal layers CM and CM' may electrically connect the first and second drain electrodes D1 and D2 to the first and second sub-pixel electrodes 221 and 221' through contact holes defined in the first planarization layer 117, respectively.

The first and second planarization layers 117 and 118 may include a single layer or layers including an organic or inorganic material layer. The first and second planarization layers 117 and 118 may each include general-purpose polymer (e.g., benzocyclobutene ("BCB"), polyimide, hexamethyldisiloxane ("HMDSO"), polymethylmethacrylate ("PMMA"), or polystyrene ("PS")), polymer derivatives having a phenolic group, acrylic-based polymer, imide-based polymer, aryl ether-based polymer, amide-based polymer, fluorine-based polymer, p-xylene-based polymer, vinyl alcohol-based polymer, or any blend thereof. On the other hand, the first and second planarization layers 117 and 118 may each include an inorganic material, such as silicon oxide, silicon nitride, silicon oxynitride, aluminum oxide, titanium oxide, tantalum oxide, hafnium oxide, or zinc oxide. After forming the first and second planarization layers 117 and 118, chemical mechanical polishing may be performed thereon to provide a flat upper surface. The first and second planarization layers 117 and 118 may each function as an insulating layer.

The second planarization layer 118 may define a contact hole that exposes the contact metal layers CM and CM'. The first sub-pixel electrode 221 may be in contact with the contact metal layer CM through the contact hole and may be electrically connected to the first source electrode S1 or the first drain electrode D1 through the contact metal layer CM, so that the first sub-pixel electrode 221 may be electrically connected to the transistor TFT.

In addition, the second sub-pixel electrode 221' may be electrically connected to the second source electrode S2 or the second drain electrode D2 through the contact metal layer CM' and thus electrically connected to the transistor TFT'. The first and second source electrodes S1 and S2 and the first and second drain electrodes D1 and D2 may be referred to as an "electrode layer".

The first and second sub-pixel electrodes 221 and 221' may each include a conductive oxide, such as indium tin oxide ("ITO"), indium zinc oxide ("IZO"), zinc oxide (ZnO), indium oxide (In₂O₃), indium gallium oxide ("IGO"), or aluminum zinc oxide ("AZO"). In another embodiment, the first and second sub-pixel electrodes 221 and 221' may each include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. In another embodiment, the first and second sub-pixel electrodes 221 and 221' may each further include a layer including ITO, IZO, ZnO, or In₂O₃ above and/or below the reflective layer. In some embodiments, the first and second sub-pixel electrodes 221 and 221' may each have a stacked structure of ITO/Ag/ITO.

A bank layer 119 may cover the edges of each of the first and second sub-pixel electrodes 221 and 221'. The bank layer 119 may overlap the first and second sub-pixel electrodes 221 and 221' in a plan view and may provide first and second openings OP1 and OP2 defining emission areas of the sub-pixels. The bank layer 119 may prevent an electric arc or the like from occurring on the edges of the first and second sub-pixel electrodes 221 and 221' by increasing the distance between the edges of the first and second sub-pixel electrodes 221 and 221' and an opposite electrode 223 on the first and second sub-pixel electrodes 221 and 221'. The bank layer 119 may include an organic insulating material, such as polyimide, polyamide, acrylic resin, BCB, HMDSO, and phenol resin, and may be formed by spin coating.

A first functional layer 222a may be disposed to cover the bank layer 119. The first functional layer 222a may be a single layer or layers. The first functional layer 222a may be a hole transport layer ("HTL") having a single-layer structure. Alternatively, the first functional layer 222a may include a hole injection layer ("HIL") and an HTL. The first functional layer 222a may be integrally formed to correspond to the first sub-pixels Pm included in the main display area MDA and the second sub-pixels Pa included in the component area CA.

First and second emission layers 222b and 222b' corresponding to the first and second sub-pixel electrodes 221 and 221', respectively, may be disposed on the first functional layer 222a. The first and second emission layers 222b and 222b' may each include a high molecular weight material or a low molecular weight material and may externally emit red light, green light, blue light, or white light.

A second functional layer 222c may be disposed on the first and second emission layers 222b and 222b'. The second functional layer 222c may be a single layer or layers. The second functional layer 222c may include an electron transport layer ("ETL") and/or an electron injection layer ("EIL"). The second functional layer 222c may be integrally formed to correspond to the first sub-pixels Pm included in the main display area MDA and the second sub-pixels Pa included in the component area CA. In another embodiment, the first functional layer 222a and/or the second functional layer 222c may be omitted.

The opposite electrode 223 may be disposed on the second functional layer 222c. The opposite electrode 223 may include a conductive material having a low work function. For example, the opposite electrode 223 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. Alternatively, the opposite electrode 223 may further include a layer including ITO, IZO, ZnO, or In₂O₃ on the (semi)transparent layer including the material described above. The opposite electrode 223 may be integrally formed to correspond to the first sub-pixels Pm included in the main display area MDA and the second sub-pixels Pa included in the component area CA.

The layers from the first sub-pixel electrode 221 disposed in the main display area MDA to the opposite electrode 223 may constitute a first organic light-emitting diode OLEDm. The layers from the second sub-pixel electrode 221' disposed in the component area CA to the opposite electrode 223 may constitute a second organic light-emitting diode OLEDa.

A capping layer 250 may be disposed on the opposite electrode 223. The capping layer 250 may include LiF. Alternatively, the capping layer 250 may include an inorganic insulating material, such as silicon nitride, and/or an organic insulating material. In some embodiments, the capping layer 250 may be omitted.

The first organic light-emitting diode OLEDm and the second organic light-emitting diode OLEDa may be sealed by an encapsulation layer 300. The encapsulation layer 300 may be disposed on the capping layer 250. The encapsulation layer 300 may prevent infiltration of external moisture or foreign material into the first organic light-emitting diode OLEDm and the second organic light-emitting diode OLEDa.

The encapsulation layer 300 may include at least one inorganic encapsulation layer and at least one organic encapsulation layer. In this regard, as an example, FIG. 7 illustrates that the encapsulation layer 300 has a structure in which a first inorganic encapsulation layer 310, an organic encapsulation layer 320, and a second inorganic encapsulation layer 330 are stacked.

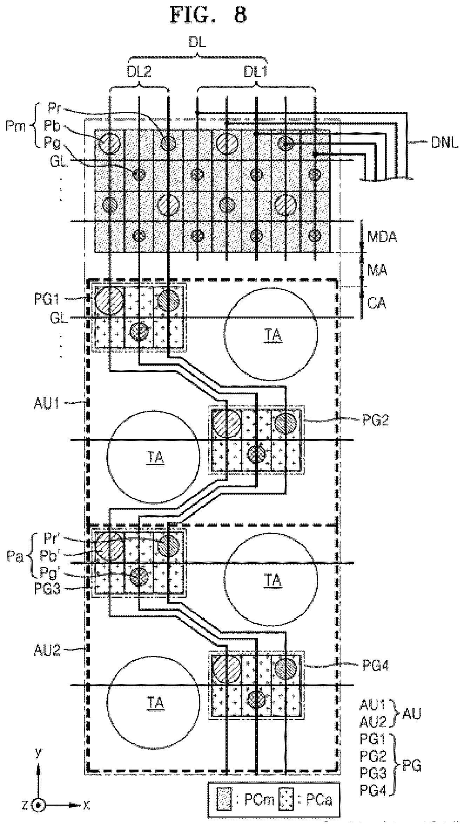

FIG. 8 is a plan view schematically illustrating a portion of a display panel according to an embodiment. FIG. 8 illustrates a portion of a main display area MDA, a component area CA, and a middle area MA included in the display area DA.

The display area DA may further include the middle area MA. The middle area MA may be between the main display area MDA and the component area CA. The middle area MA may be an area corresponding to a boundary between the main display area MDA and the component area CA. The middle area MA may be an area in which a first sub-pixel Pm and a second sub-pixel Pa are not disposed. In FIG. 8, the middle area MA is described as being between the main display area MDA and the component area CA, but the middle area MA may be a portion of the component area CA, i.e., a transmission area TA of the component area CA in another embodiment. Lines extending from the main display area MDA to the component area CA may be disposed in the middle area MA. As the number of lines extending from the main display area MDA to the component area CA decreases, the area of the middle area MA may be reduced.

Referring to FIG. 8, first sub-pixels Pm may be disposed in the main display area MDA. For example, FIG. 8 illustrates that the first sub-pixels Pm (i.e., display elements of the first sub-pixels Pm) are disposed in the PenTile structure of FIG. 5. In the main display area MDA, first sub-pixel circuits PCm may be disposed to overlap the display elements of the first sub-pixels Pm in a plan view. The first sub-pixel circuits PCm may be disposed in a matrix shape along the x direction and the y direction.

Second sub-pixels Pa may be disposed in the component area CA. In the component area CA, transmission areas TA and sub-pixel groups PG including the second sub-pixels Pa may be alternately disposed along the x direction. In an embodiment, the sub-pixel groups PG and the transmission areas TA may be alternately disposed in the component area CA along the x direction and the y direction. In the component area CA, basic units AU each including a certain number of sub-pixel groups PG and a certain number of transmission areas TA may be repeatedly disposed in the x direction and the y direction. For example, FIG. 8 illustrates that the second sub-pixels Pa (display elements of the second sub-pixels Pa) are disposed in the pixel disposition structure of FIG. 6A. In the component area CA, the second sub-pixel circuits PCa may be disposed to overlap the display elements of the second sub-pixels Pa in a plan view. The second sub-pixel circuits PCa may be disposed in groups. The groups of the sub-pixel circuits may be apart from each other.

FIG. 8 illustrates a first basic unit AU1 and a second basic unit AU2 disposed in the same column as a portion of the component area CA. Although FIG. 8 illustrates only two basic units AU in the component area CA, this is only for convenience of explanation, and three or more basic units AU may be disposed in the component area CA. In an embodiment, one basic unit AU may include two sub-pixel groups PG and two transmission areas TA, which are alternately disposed along the x direction and the y direction. The first basic unit AU1 may include a first sub-pixel group PG1 and a second sub-pixel group PG2, which are disposed in different rows and columns from each other. The second basic unit AU2 may include a third sub-pixel group PG3 and a fourth sub-pixel group PG4, which are disposed in different rows and columns from each other.

Data lines DL may extend in the display area DA along the y direction (e.g., column direction). The data lines DL may include first data lines DL1 and second data lines DL2. In an embodiment, the first data line DL1 may be a "first line", and the second data line DL2 may be a "second line". Although FIG. 8 illustrates only eight data lines DL corresponding to a portion of the component area CA, this is only for convenience of explanation, and nine or more data lines DL may be disposed in the display area DA.

The first data lines DL1 may each be electrically connected to the first sub-pixels Pm disposed in the main display area MDA along the same column. In the present specification, the expression "the line is connected to the sub-pixel" may mean that the line configured to supply signals and power to the sub-pixel is connected to the sub-pixel circuit. For example, the expression "the line is connected to the first sub-pixel Pm" may mean that the line is connected to the first sub-pixel circuit PCm included in the first sub-pixel Pm. The expression "the line is connected to the second sub-pixel Pa" may mean that the line is connected to the second sub-pixel circuit PCa included in the second sub-pixel Pa.

The first data lines DL1 may bypass the component area CA through first connection lines DNL disposed in the main display area MDA. The first data lines DL1 may not overlap the component area CA including the transmission area TA in a plan view. This structure may improve the light transmittance of the transmission area TA.

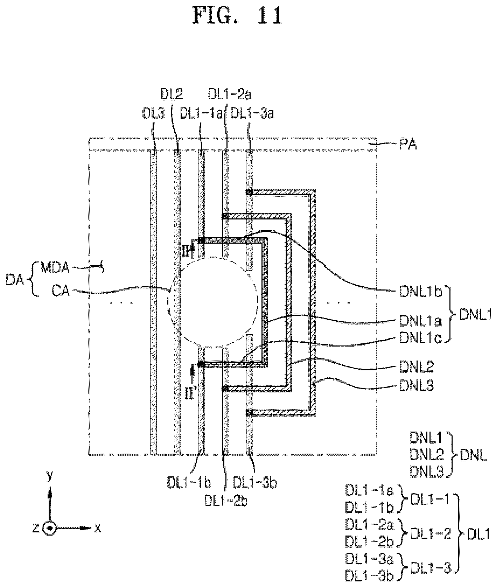

Each of the first data lines DL1 may include a first sub-line and a second sub-line apart from each other with the component area CA therebetween, and the first connection lines DNL may electrically connect the first sub-line and the second sub-line of each of the first data lines DL1 to each other. The line structure in which the first data lines DL1 bypass the component area CA is specifically described below with reference to FIG. 11.

The second data lines DL2 may extend in the component area CA along the y direction (e.g., column direction). The second data lines DL2 may be electrically connected to the second sub-pixels Pa in the component area CA. The second data lines DL2 may be connected to sub-pixel groups PG of different rows constituting one basic unit AU. The expression "the data line is connected to the sub-pixel group" may mean that the data line is connected to at least one of the sub-pixels included in the sub-pixel group. For example, the second data lines DL2 may be connected to the first sub-pixel group PG1 and the second sub-pixel group PG2 disposed in different rows of the first basic unit AU1. The second data lines DL2 may be connected to the third sub-pixel group PG3 and the fourth sub-pixel group PG4 of the second basic unit AU2 disposed in different rows.

When connected to the sub-pixel groups PG of different rows constituting the basic unit AU, each of the second data lines DL2 may be connected to the second sub-pixels Pa disposed in the same column within each of the sub-pixel groups PG. For example, the second data line DL2 connected to the second blue sub-pixel Pb' of the first column of the first sub-pixel group PG1 may be connected to the second blue sub-pixel Pb' of the first column of the second sub-pixel group PG2 as shown in FIG. 8. Similarly, the second data line DL2 connected to the second green sub-pixel Pg' of the second column of the first sub-pixel group PG1 may be connected to the second green sub-pixel Pg' of the second column of the second sub-pixel group PG2. The second data line DL2 connected to the second red sub-pixel Pr' of the third column of the first sub-pixel group PG1 may be connected to the second red sub-pixel Pr' connected to the third column of the second sub-pixel group PG2.

The second data lines DL2 may pass through basic units AU disposed in the same column of each sub-pixel group. For example, the second data lines DL2 may pass through the first basic unit AU1 and the second basic unit AU2 disposed in the same column of each sub-pixel group. The second data lines DL2 may be connected to the sub-pixel groups PG constituting each of the basic units AU disposed in the same column. Similarly, the second data lines DL2 may be connected to the second sub-pixels Pa disposed in the same column within each of the sub-pixel groups PG. For example, the second data line DL2 connected to the second blue sub-pixel Pb' of the first column of the second sub-pixel group PG2 included in the first basic unit AU1 may be connected to the second blue sub-pixel Pb' of the first column of the third sub-pixel group PG3 included in the second basic unit AU2.

The number of second data lines DL2 passing through the basic unit AU may be equal to the number of second sub-pixels Pa included in one sub-pixel group PG within the basic unit AU. For example, because one sub-pixel group PG of FIG. 8 includes three second sub-pixels Pa, that is, one second blue sub-pixel Pb', one second green sub-pixel Pg', and one second red sub-pixel Pr', which are disposed in different columns of the sub-pixel group PG, the number of second data lines DL2 passing through the basic unit AU may be three. Therefore, the number of second data lines DL2 passing through the basic unit AU may vary depending on the disposition structure of the second sub-pixels Pa. In an embodiment, the second data lines DL2 passing through the basic unit AU may be disposed sequentially.

In an advantageous embodiment with respect to an increase of the light transmittance of the transmission area TA, the second data lines DL2 may be disposed to bypass the transmission area TA within the component area CA. The second data lines DL2 may extend between the sub-pixel groups PG and the transmission areas TA. Alternatively, the second data lines DL2 may overlap at least a portion of the transmission area TA disposed in the component area CA in a plan view. Even in this case, in order to increase the light transmittance of the transmission area TA, the second data lines DL2 may be disposed to bypass the central portion of the transmission area TA so as to be biased toward one side.

The second data lines DL2 may extend to the main display area MDA along the y direction (e.g., column direction). The second data lines DL2 may be connected to the first sub-pixels Pm of the main display area MDA disposed along the same column as the second sub-pixels Pa included in the sub-pixel groups PG (e.g., first sub-pixel group PG1) disposed in the first row among the sub-pixel groups PG of the component area CA. The second data lines DL2 may be connected to the first sub-pixels Pm of the main display area MDA disposed along the same column as the second sub-pixels Pa included in the sub-pixel groups PG disposed in the first row among the sub-pixel groups PG within the basic unit AU. For example, as illustrated in FIG. 8, the second data lines DL2 may be connected to the first sub-pixels Pm of the main display area MDA disposed along the same column as the second sub-pixels Pa included in the first sub-pixel group PG1 disposed in the first row of the first basic unit AU1.

In other words, the second data lines DL2 of the data lines DL disposed in the columns corresponding to the component area CA among the columns of the main display area MDA may extend to the component area CA and may be connected to the second sub-pixels Pa. The first data lines DL1 of the data lines DL disposed in the columns corresponding to the component area CA among the columns of the main display area MDA may bypass the component area CA without passing through the component area CA. The first sub-pixels Pm connected to the second data lines DL2 in the main display area MDA may be disposed in the same column as the second sub-pixels Pa included in the sub-pixel groups PG of the first row of the component area CA. The first sub-pixels Pm connected to the first data lines DL1 in the main display area MDA may correspond to the transmission areas TA disposed in the first row of the component area CA.

The number of second data lines DL2 passing through the component area CA and the number of first data lines DL1 bypassing the component area CA may vary depending on the disposition structure of the second sub-pixels Pa in the component area CA. For example, FIG. 8 illustrates that, among eight data lines DL disposed in the columns corresponding to the component area CA in the main display area MDA, three second data lines DL2 are connected to the sub-pixel group PG including three second sub-pixels Pa, and five first data lines DL1 bypass the component area CA.

Scan lines GL may extend in the main display area MDA along the x direction (e.g., row direction). The scan lines GL may be connected to the first sub-pixels Pm disposed in the same column in the main display area MDA. Some of the scan lines GL may extend to the component area CA. Some of the scan lines GL may extend in the component area CA along the x direction (i.e., row direction) and may be connected to the second sub-pixels Pa of the same row. The scan line GL may be configured to receive a scan signal from the first driving circuit (see 3031 of FIG. 3A) and/or the second driving circuit (see 3032 of FIG. 3A). Each of the second sub-pixels Pa may be configured to emit light with a luminance corresponding to the data signal received from the connected second data line DL2 when the scan signal is applied from the connected scan line GL.

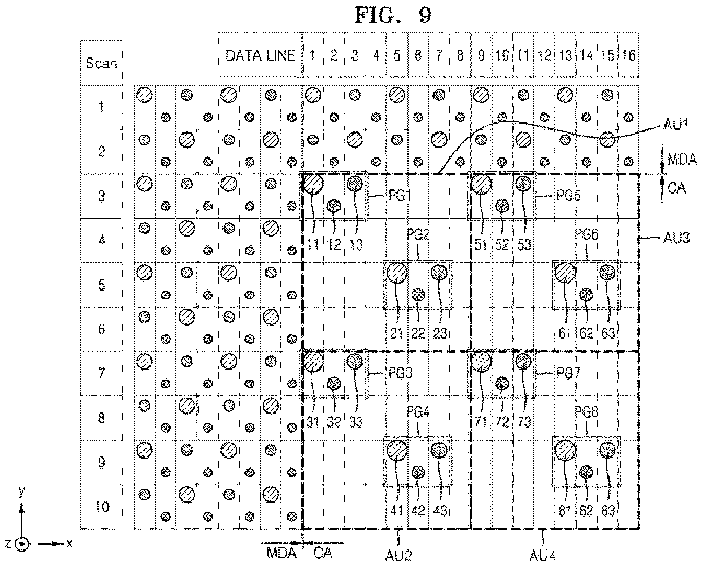

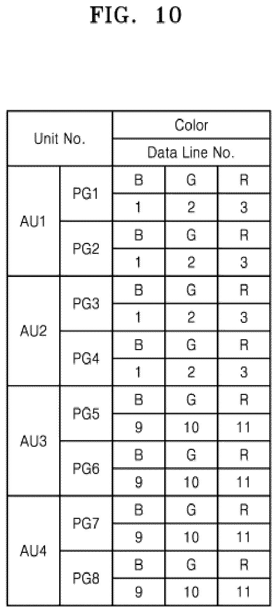

FIGS. 9 and 10 are diagrams for describing the application of scan signals and data signals to the component area of the display panel according to an embodiment. The numbers on the left side of FIG. 9 indicate the order of scan lines or scan signals, and the numbers on the upper side of FIG. 9 indicate the order of data lines disposed in the columns corresponding to the component area CA among the columns of the main display area MDA. The middle area MA is omitted. For example, FIG. 9 illustrates the order of ten scan lines in the first to tenth rows of the main display area MDA and sixteen data lines disposed in sixteen columns corresponding to the component area CA. FIG. 10 illustrates emission colors and data lines connected to second sub-pixels included in sub-pixel groups within basic units.

Referring to FIGS. 9 and 10, second sub-pixels 11, 12, and 13 provided in a first sub-pixel group PG1 of a first basic unit AU1 may be connected to first, second, and third data lines, respectively, among the sixteen data lines. Second sub-pixels 21, 22, and 23 provided in a second sub-pixel group PG2 of the first basic unit AU1 may be connected to the first, second, and third data lines, respectively, among the sixteen data lines.

Second sub-pixels 31, 32, and 33 provided in a third sub-pixel group PG3 of a second basic unit AU2 may be connected to the first, second, and third data lines, respectively, among the sixteen data lines. Second sub-pixels 41, 42, and 43 provided in a fourth sub-pixel group PG4 of the second basic unit AU2 may be connected to the first, second, and third data lines, respectively, among the sixteen data lines.

Second sub-pixels 51, 52, and 53 provided in a fifth sub-pixel group PG5 of a third basic unit AU3 may be connected to ninth, tenth, and eleventh data lines, respectively, among the sixteen data lines. Second sub-pixels 61, 62, and 63 provided in a sixth sub-pixel group PG6 of the third basic unit AU3 may be connected to the ninth, tenth, and eleventh data lines, respectively, among the sixteen data lines.

Second sub-pixels 71, 72, and 73 provided in a seventh sub-pixel group PG7 of a fourth basic unit AU4 may be connected to the ninth, tenth, and eleventh data lines, respectively, among the sixteen data lines. Second sub-pixels 81, 82, and 83 provided in an eighth sub-pixel group PG8 of the fourth basic unit AU4 may be connected to the ninth, tenth, and eleventh data lines, respectively, among the sixteen data lines.

As described above with reference to FIG. 8, some of the data lines disposed in the columns corresponding to the component area CA among the columns of the main display area MDA may not pass through the component area CA. For example, fourth to eighth data lines and twelfth to sixteenth data lines may not extend to the component area CA. The fourth to eighth data lines and the twelfth to sixteenth data lines may not be connected to the sub-pixels of the component area CA.

The first, second, and third data lines and the ninth, tenth, and eleventh data lines among the sixteen data lines may correspond to the second data lines DL2 of FIG. 8. The fourth to eighth data lines and the twelfth to sixteenth data lines among the sixteen data lines may correspond to the first data lines DL1 of FIG. 8. The fourth to eighth data lines and the twelfth to sixteenth data lines may bypass the component area CA through first connection lines disposed in the main display area MDA.

The second sub-pixels 11, 12, and 13 provided in the first sub-pixel group PG1 of the first basic unit AU1 and the second sub-pixels 51, 52, and 53 provided in the fifth sub-pixel group PG5 of the third basic unit AU3 may be connected to the third scan line among the ten scan lines.

The second sub-pixels 21, 22, and 23 provided in the second sub-pixel group PG2 of the first basic unit AU1 and the second sub-pixels 61, 62, and 63 provided in the sixth sub-pixel group PG6 of the third basic unit AU3 may be connected to the fifth scan line among the ten scan lines.

The second sub-pixels 31, 32, and 33 provided in the third sub-pixel group PG3 of the second basic unit AU2 and the second sub-pixels 71, 72, and 73 provided in the seventh sub-pixel group PG7 of the fourth basic unit AU4 may be connected to the seventh scan line among the ten scan lines.

The second sub-pixels 41, 42, and 43 provided in the fourth sub-pixel group PG4 of the second basic unit AU2 and the second sub-pixels 81, 82, and 83 provided in the eighth sub-pixel group PG8 of the fourth basic unit AU4 may be connected to the ninth scan line among the ten scan lines.

When a scan signal is applied to the third scan line, data signals may be applied to the second sub-pixels 11 to 13 and 51 to 53 provided in the first sub-pixel group PG1 of the first basic unit AU1 and the fifth sub-pixel group PG5 of the third basic unit AU3, respectively. When a scan signal is applied to the fifth scan line, data signals may be applied to the second sub-pixels 21 to 23 and 61 to 63 provided in the second sub-pixel group PG2 of the first basic unit AU1 and the sixth sub-pixel group PG6 of the third basic unit AU3, respectively.

Similarly, when a scan signal is applied to the seventh scan line, data signals may be applied to the second sub-pixels 31 to 33 and 71 to 73 provided in the third sub-pixel group PG3 of the second basic unit AU2 and the seventh sub-pixel group PG7 of the fourth basic unit AU4, respectively. When a scan signal is applied to the ninth scan line, data signals may be applied to the second sub-pixels 41 to 43 and 81 to 83 provided in the fourth sub-pixel group PG4 of the second basic unit AU2 and the eighth sub-pixel group PG8 of the fourth basic unit AU4, respectively. The second sub-pixels may be configured to emit light with a luminance corresponding to the data signals provided from the connected data lines.

The second data lines may be connected to the first sub-pixels of the main display area MDA disposed along the same column as the second sub-pixels of the sub-pixel groups of the first row within the component area CA. In an embodiment, the scan lines connected to the second sub-pixels and the applied data signals may be determined by the disposition structure of virtual first sub-pixels disposed in the component area CA. For example, in FIG. 9, the scan lines connected to the second sub-pixels and the applied data signals may be determined according to the disposition structure of the virtual first sub-pixels on the assumption that the first sub-pixels disposed in the first to third columns of the main display area MDA connected to the first to third data lines are also disposed consecutively in the first to third columns of the component area CA. For example, blue sub-pixels and red sub-pixels may be alternately disposed in the first column of the main display area MDA corresponding to the component area CA, green sub-pixels may be alternately disposed in the second column, and red sub-pixels and blue sub-pixels may be alternately disposed in the third column. The second sub-pixels 11, 21, 31, and 41 connected to the first data line and connected to the third, fifth, seventh, and ninth scan lines, respectively, may correspond to the blue sub-pixels. The second sub-pixels 12, 22, 32, and 42 connected to the second data line and connected to the third, fifth, seventh, and ninth scan lines, respectively, may correspond to the green sub-pixels. The second sub-pixels 13, 23, 33, and 43 connected to the third data line and connected to the third, fifth, seventh, and ninth scan lines, respectively, may correspond to the red sub-pixels.

The application of the scan signals and the data signals to the second sub-pixels, as described with reference to FIGS. 9 and 10, may be equally applied to subsequent basic units.

FIG. 11 is a plan view schematically illustrating a line disposition structure around a component area of a display panel according to an embodiment.

Referring to FIG. 11, data lines DL configured to apply data signals to sub-pixels may be disposed in a display area DA. The data lines DL may extend in the y direction and may be disposed approximately parallel to each other. Although FIG. 11 illustrates only five data lines as data lines DL adjacent to a component area CA, this is only for convenience of explanation, and six or more data lines DL may be disposed in the display area DA. The data lines DL may include first data lines DL1, second data lines DL2, and third data lines DL3. The first data lines DL1 and the second data lines DL2 illustrated in FIG. 11 may correspond to the first data lines DL1 and the second data lines DL2, respectively, described with reference to FIGS. 8 to 10.

The first data lines DL1 may each include a first sub-line and a second sub-line apart from each other with the component area CA therebetween. For example, the first data lines DL1 may include a first-1 data line DL1-1, a first-2 data line DL1-2, and a first-3 data line DL1-3. The first-1 data line DL1-1 may include a first sub-line DL1-1a and a second sub-line DL1-1b apart from each other by the component area CA. The second sub-line DL1-1b of the first-1 data line DL1-1 may be disposed to coincide with an imaginary line extending from the first sub-line DL1-1a in the y direction. Similarly, the first-2 data line DL1-2 may include a first sub-line DL1-2a and a second sub-line DL1-2b apart from each other by the component area CA. The first-3 data line DL1-3 may include a first sub-line DL1-3a and a second sub-line DL1-3b apart from each other by the component area CA.

Unlike the first data line DL1, the second data line DL2 may be disposed to pass through the component area CA. The third data line DL3 may be integrally formed without any part being disconnected or apart by the component area CA. Unlike the second data line DL2, the third data line DL3 may not have any portion overlapping the component area CA in a plan view.

FIG. 11 illustrates three first data lines DL1, one second data line DL2, and one third data line DL3, but this is only for convenience of explanation, and four or more first data lines DL1, two or more second data lines DL2, and two or more third data lines DL3 may be disposed in the display area DA.

First connection lines DNL may be disposed in the main display area MDA of the display area DA. The first connection line DNL may be disposed to bypass the component area CA. The first connection lines DNL may electrically connect the first sub-line and the second sub-line of each of the first data lines DL1 to each other. For example, the first connection lines DNL may include a first-1 connection line DNL1, a first-2 connection line DNL2, and a first-3 connection line DNL3. The first-1 connection line DNL1 may electrically connect the first sub-line DL1-1a and the second sub-line DL1-1b of the first-1 data line DL1-1 to each other. The first-2 connection line DNL2 may electrically connect the first sub-line DL1-2a and the second sub-line DL1-2b of the first-2 data line DL1-2 to each other. The first-3 connection line DNL3 may electrically connect the first sub-line DL1-3a and the second sub-line DL1-3b of the first-2 data line DL1-3 to each other.

The same signal may be applied to the first sub-line DL1-1a and the second sub-line DL1-1b of the first-1 data line DL1-1 through the first-1 connection line DNL1. Although the description is given based on the first-1 connection line DNL1, the same may also be applied to the first-2 connection line DNL2 and the first-3 connection line DNL3.

The first-1 connection line DNL1 may not be connected to or in contact with the first-2 data line DL1-2 and the first-3 data line DL1-3. Different signals may be applied to the first-1 data line DL1-1, the first-2 data line DL1-2, and the first-3 data line DL1-3.

In an embodiment, the first-1 connection line DNL1 may be disposed to be closest to the component area CA, the first-3 connection line DNL3 may be disposed to be farthest from the component area CA, and the first-2 connection line DNL2 may be between the first-1 connection line DNL1 and the first-3 connection line DNL3. However, the disclosure is not necessarily limited thereto, and the shape in which the first-1 to first-3 connection lines DNL1, DNL2, and DNL3 are disposed may vary.

The first connection line DNL may include a first portion extending in the y direction, a second portion connected to one end of the first portion and extending in the x direction, and a third portion connected to the other end of the first portion and extending in the x direction. For example, the first-1 connection line DNL1 may include a first portion DNL1a extending in the y direction, a second portion DNL1b extending in the x direction, and a third portion DNL1c. The second portion DNL1b may be connected to one end of the first portion DNL1a, and the third portion DNL1c may be connected to the other end of the first portion DNL1a.

In an embodiment, the first portion DNL1a of the first-1 connection line DNL1 may be disposed in the same row as any one of the vertical common voltage lines VSL described above with reference to FIGS. 3A and 3B. The second portion DNL1b and the third portion DNL1c of the first-1 connection line DNL1 may be disposed in the same row as any one of the horizontal common voltage lines HSL described above with reference to FIGS. 3A and 3B. Although the description is given based on the first-1 connection line DNL1, the same may also be applied to the first-2 connection line DNL2 and the first-3 connection line DNL3.

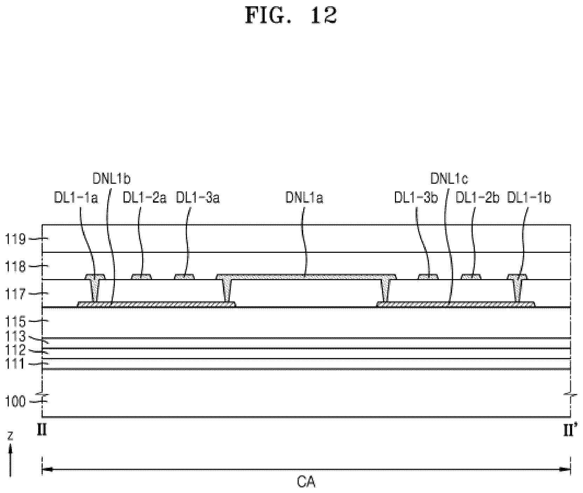

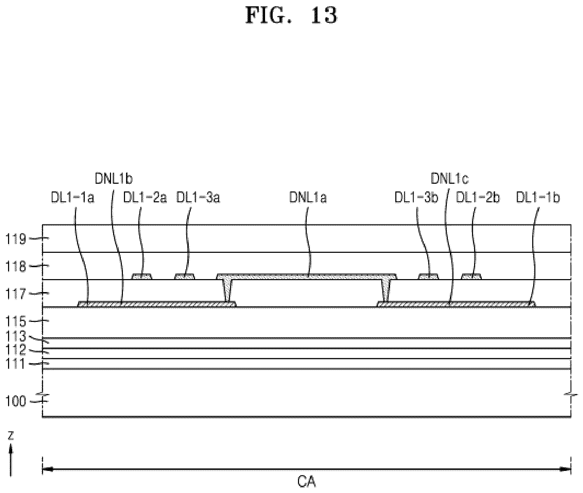

FIG. 12 is a cross-sectional view taken along line II-II' of FIG. 11 and illustrating data lines and first connection lines of a display panel according to an embodiment, and FIG. 13 illustrates a modification of FIG. 12. FIGS. 12 and 13 are cross-sectional views illustrating the first-1 connection line DNL1 that electrically connects the first sub-line DL1-1a and the second sub-line DL1-1b of the first-1 data line DL1-1 to each other, as an example of the first connection line DNL.

Referring to FIGS. 12 and 13, a buffer layer 111, a first gate insulating layer 112, a second gate insulating layer 113, and an interlayer-insulating layer 115 may be sequentially disposed on a substrate 100.

In an embodiment, the second portion DNL1b and the third portion DNL1c of the first-1 connection line DNL1 may be disposed on a different layer from the first portion DNL1a of the first-1 connection line DNL1. The second portion DNL1b and the third portion DNL1c of the first-1 connection line DNL1 may be disposed on the interlayer-insulating layer 115. A first planarization layer 117 may be disposed to cover the second portion DNL1b and the third portion DNL1c of the first-1 connection line DNL1.

The first sub-line DL1-1a and the second sub-line DL1-1b of the first-1 data line DL1-1 and the first portion DNL1a of the first-1 connection line DNL1 may be disposed on the first planarization layer 117. The first sub-line DL1-1a of the first-1 data line DL1-1 may be electrically connected to the second portion DNL1b of the first-1 connection line DNL1 through a contact hole of the first planarization layer 117. The second sub-line DL1-1b of the first-1 data line DL1-1 may be electrically connected to the third portion DNL1c of the first-1 connection line DNL1 through a contact hole of the first planarization layer 117. The first portion DNL1a of the first-1 connection line DNL1 may be electrically connected to the second portion DNL1b and the third portion DNL1c of the first-1 connection line DNL1 through contact holes of the first planarization layer 117.

In addition, the first and second sub-lines DL1-2a and DL1-2b of the first-2 data line DL1-2 and the first and second sub-lines DL1-3a and DL1-3b of the first-3 data line DL1-3 may be disposed on the first planarization layer 117. The first-2 data line DL1-2 and the first-3 data line DL1-3 may not be connected to or in contact with the first-1 connection line DNL1 of the first-1 data line DL1-1.

The second portion DNL1b and the third portion DNL1c of the first-1 connection line DNL1 may be disposed on the same layer as the first and second source electrodes S1 and S2 and the first and second drain electrodes D1 and D2 of the transistor TFT and TFT' of FIG. 7 and may include the same materials as materials of the first and second source electrodes S1 and S2 and the first and second drain electrodes D1 and D2.

The first portion DNL1a of the first-1 connection line DNL1, the first sub-line DL1-1a and the second sub-line DL1-1b of the first-1 data line DL1-1, the first-2 data line DL1-2, and the first-3 data line DL1-3 may be disposed on the same layer as the contact metal layers CM and CM' of FIG. 7 and may include the same materials as those of the contact metal layers CM and CM'.

Referring to FIG. 13, in another embodiment, the first sub-line DL1-1a and the second sub-line DL1-1b of the first-1 data line DL1-1 may be disposed on the interlayer-insulating layer 115. In another embodiment, the first sub-line DL1-1a and the second sub-line DL1-1b of the first-1 data line DL1-1 may be integrally provided as a single body with the second portion DNL1b and the third portion DNL1c of the first-1 connection line DNL1, respectively. In this case, the first sub-line DL1-1a and the second sub-line DL1-1b of the first-1 data line DL1-1 may be disposed on the same layer as the first and second source electrodes S1 and S2 and the first and second drain electrodes D1 and D2 of the transistor TFT and TFT' of FIG. 7 and may include the same materials as materials of the first and second source electrodes S1 and S2 and the first and second drain electrodes D1 and D2.

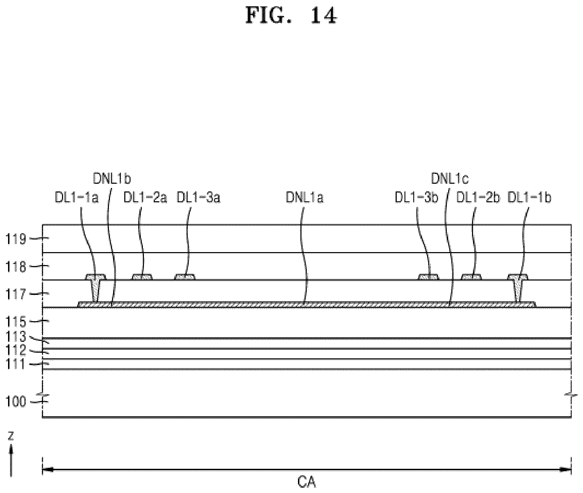

FIG. 14 is a cross-sectional view illustrating data lines and first connection lines of a display panel according to an embodiment and illustrates a modification of FIG. 12. FIG. 14 is a cross-sectional view illustrating a first-1 connection line DNL1 that electrically connects a first sub-line DL1-1a and a second sub-line DL1-1b of a first-1 data line DL1-1 to each other, as an example of the first connection line DNL. Hereinafter, the differences from the embodiment of FIG. 12 are mainly described, and redundant descriptions thereof are omitted.

Referring to FIG. 14, in an embodiment, a second portion DNL1b and a third portion DNL1c of the first-1 connection line DNL1 may be disposed on the same layer as a first portion DNL1a of the first-1 connection line DNL1. In another embodiment, the first portion DNL1a, the second portion DNL1b, and the third portion DNL1c of the first-1 connection line DNL1 may be integrally provided as a single body.

The first portion DNL1a, the second portion DNL1b, and the third portion DNL1c of the first-1 connection line DNL1 may be disposed on an interlayer-insulating layer 115. A first planarization layer 117 may be disposed on the first-1 connection line DNL1.

The first portion DNL1a, the second portion DNL1b, and the third portion DNL1c of the first-1 connection line DNL1 may be integrally provided as a single body and may be disposed on the same layer as the first and second source electrodes S1 and S2 and the first and second drain electrodes D1 and D2 of the transistor TFT and TFT' of FIG. 7 and may include the same materials as materials of the first and second source electrodes S1 and S2 and the first and second drain electrodes D1 and D2.

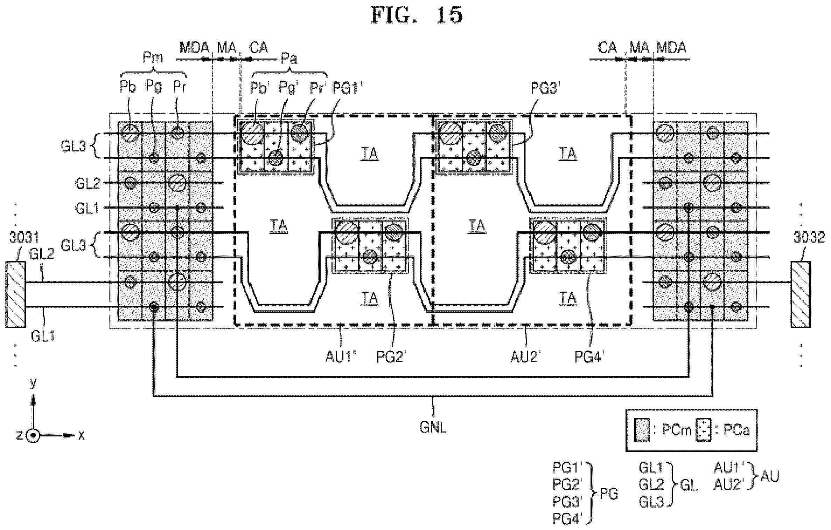

FIG. 15 is a plan view schematically illustrating a portion of a display panel according to an embodiment. FIG. 15 illustrates a portion of a main display area MDA, a component area CA, and a middle area MA included in a display area DA.

Referring to FIG. 15, first sub-pixels Pm may be disposed in the main display area MDA. For example, FIG. 15 illustrates that the first sub-pixels Pm (i.e., display elements of the first sub-pixels Pm) are disposed in the PenTile structure of FIG. 5. In the main display area MDA, first sub-pixel circuits PCm may be disposed to overlap the display elements of the first sub-pixels Pm in a plan view. The first sub-pixel circuits PCm may be disposed in a matrix shape along the x direction and the y direction.

Second sub-pixels Pa may be disposed in the component area CA. In an embodiment, sub-pixel groups PG and transmission areas TA may be alternately disposed in the component area CA along the x direction and the y direction. In the component area CA, basic units AU each including a certain number of sub-pixel groups PG and a certain number of transmission areas TA may be repeatedly disposed in the x direction and the y direction. For example, FIG. 15 illustrates that the second sub-pixels Pa (display elements of the second sub-pixels Pa) are disposed in the pixel disposition structure of FIG. 6A. In the component area CA, the second sub-pixel circuits PCa may be disposed to overlap the display elements of the second sub-pixels Pa in a plan view. The second sub-pixel circuits PCa may be disposed in groups. The groups of the sub-pixel circuits may be apart from each other.

FIG. 15 illustrates a first basic unit AU1' and a second basic unit AU2' disposed in the same row as a portion of the component area CA. Although FIG. 15 illustrates that two basic units AU are disposed in one row in the component area CA, this is only for convenience of explanation, and three or more basic units AU may be disposed in one row in the component area CA. The basic unit AU' may include two sub-pixel groups PG and two transmission areas TA, which are alternately disposed along the x direction and the y direction. The first basic unit AU' may include a first sub-pixel group PG1' and a second sub-pixel group PG2', which are disposed in different rows and columns. The second basic unit AU' may include a third sub-pixel group PG3' and a fourth sub-pixel group PG4', which are disposed in different rows and columns.

Scan lines GL may extend in the display area DA along the x direction (e.g., row direction). The scan lines GL may include first scan lines GL1, second scan lines GL2, and third scan lines GL3. In an embodiment, the first scan line GL1 and the second scan line GL2 may be a "third line", and the third scan line GL3 may be a "fourth line". Although FIG. 15 illustrates only eight scan lines GL corresponding to a portion of the component area CA, this is only for convenience of explanation, and nine or more scan lines GL may be disposed in the display area DA.

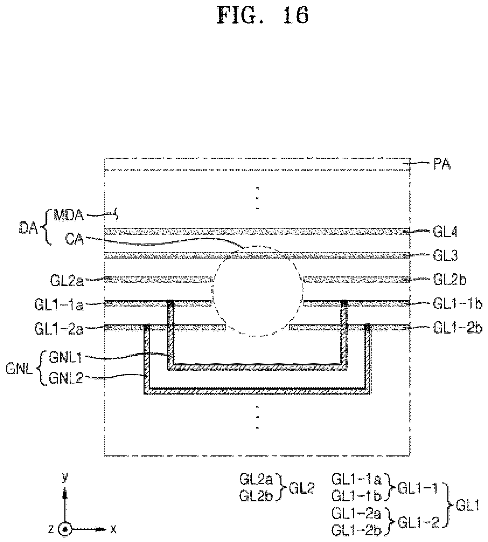

The first scan lines GL1 and the second scan lines GL2 may each be electrically connected to a first sub-pixel Pm disposed in the main display area MDA along the same row. The first scan lines GL1 may bypass the component area CA through second connection lines GNL disposed in the main display area MDA. The first scan lines GL1 and the second scan lines GL2 may not overlap the component area CA in a plan view. The first scan lines GL1 and the second scan lines GL2 may each include a first sub-line and a second sub-line apart from each other with the component area CA therebetween. The second connection lines GNL may electrically connect the first sub-line and the second sub-line of each of the first scan lines GL1 to each other. The line structure in which the first scan lines GL1 bypass the component area CA is specifically described below with reference to FIG. 16.

The first scan lines GL1 may be connected to any one of a first driving circuit 3031 disposed on the left side of a peripheral area PA and a second driving circuit 3032 disposed on the right side thereof. The first scan lines GL1 may be configured to receive scan signals from any one of the first driving circuit 3031 and the second driving circuit 3032.

The second scan lines GL2 may be connected to the first driving circuit 3031 disposed on the left side of the peripheral area PA and the second driving circuit 3032 disposed on the right side thereof. One end of each of the second scan lines GL2 may be connected to the first driving circuit 3031 and the other end thereof may be connected to the second driving circuit 3032. Accordingly, even when the second scan line GL2 includes the first sub-line and the second sub-line apart from each other with the component area CA therebetween, the scan signals received from the first driving circuit 3031 and the second driving circuit 3032 may be applied to the first sub-pixels Pm disposed on the left side of the component area CA and connected to the second scan lines GL2 and the first sub-pixels Pm disposed on the right side of the component area CA and connected to the second scan lines GL2, respectively.

In an embodiment, a first gate line GWL, a second gate line GIL, a third gate line GCL, and an emission control line EL shown in FIG. 4B may be connected to the first sub-pixel circuit PCm of the first sub-pixel Pm and the second sub-pixel circuit PCa of the second sub-pixel Pa. Alternatively, the first gate line GWL, the second gate line GIL, the third gate line GCL, a fourth gate line GBL, and the emission control line EL may be connected to the first sub-pixel circuit PCm of the first sub-pixel Pm and the second sub-pixel circuit PCa of the second sub-pixel Pa. In this case, the first scan lines GL1 may be the second gate line GIL, the third gate line GCL, and/or the emission control line EL. The second scan lines GL2 may be the first gate line GWL and/or the fourth gate line GBL.

The first scan lines GL1 that are not connected to the second sub-pixels Pa of the component area CA may be disposed to bypass the component area CA through the second connection line GNL, and the second scan lines GL2 may be apart from each other by the component area CA. The number of lines passing through the component area CA may be reduced. This structure may improve the light transmittance of the component area CA.

The third scan lines GL3 may extend in the component area CA along the x direction (e.g., row direction). The third scan lines GL3 may be electrically connected to the second sub-pixels Pa in the component area CA. The third scan lines GL3 may pass through basic units AU disposed in the same row. The third scan lines GL3 may be connected to the sub-pixel groups PG disposed in the same row. In other words, the third scan lines GL3 may be connected to the groups of the second sub-pixel circuits PCa disposed in the same row. For example, the third scan lines GL3 may be disposed to pass through the first basic unit AU1' and the second basic unit AU2' disposed in the same row. The third scan lines GL3 connected to the first sub-pixel group PG1' of the first basic unit AU1' may be connected to the third sub-pixel group PG3' of the second basic unit AU2' disposed in the same row. The third scan lines GL3 connected to the second sub-pixel group PG2' of the first basic unit AU1' may be connected to the fourth sub-pixel group PG4' of the second basic unit AU2' disposed in the same row.

The third scan lines GL3 may extend to the main display area MDA along the x direction (e.g., row direction). In an embodiment, the third scan lines GL3 may be disposed to bypass the transmission area TA within the component area CA. The third scan lines GL3 may be between the sub-pixel groups PG and the transmission areas TA. Alternatively, the third scan lines GL3 may overlap at least a portion of the transmission areas TA disposed in the component area CA in a plan view. Even in this case, in order to increase the light transmittance of the transmission areas TA, the third scan lines GL3 may be disposed to bypass the central portion of the transmission areas TA so as to be biased toward one side.

The third scan lines GL3 may be configured to receive scan signals from the first driving circuit 3031 and/or the second driving circuit 3032.

FIG. 16 is a plan view schematically illustrating a line disposition structure around a component area of a display panel according to an embodiment.

Referring to FIG. 16, scan lines GL configured to apply scan signals to sub-pixels may be disposed in a display area DA. The scan lines GL may extend in the x direction and may be disposed approximately parallel to each other. Although FIG. 16 illustrates only five scan lines as scan lines GL adjacent to a component area CA, this is only for convenience of explanation, and six or more scan lines GL may be disposed in the display area DA. The scan lines GL may include first scan lines GL1, second scan lines GL2, third scan lines GL3, and fourth scan lines GL4. The first to third scan lines GL1 to GL3 illustrated in FIG. 16 may correspond to the first to third scan lines GL1 to GL3 described with reference to FIG. 15, respectively.

The first scan lines GL1 may each include a first sub-line and a second sub-line apart from each other with the component area CA therebetween. For example, the first scan line GL1 may include a first-1 scan line GL1-1 and a first-2 scan line GL1-2. The first-1 scan line GL1-1 may include a first sub-line GL1-1a and a second sub-line GL1-1b apart from each other by the component area CA. The second sub-line GL1-1b of the first-1 scan line GL1-1 may be disposed to coincide with an imaginary line extending from the first sub-line GL1-1a in the x direction. Similarly, the first-2 scan line GL1-2 may include a first sub-line GL1-2a and a second sub-line GL1-2b apart from each other by the component area CA.

Unlike the first scan line GL1, the second scan line GL2 may include a first sub-line GL2a and a second sub-line GL2b apart from each other with the component area CA therebetween. The second sub-line GL2b of the second scan line GL2 may be disposed to coincide with an imaginary line extending from the first sub-line GL2a in the x direction.

Unlike the first scan line GL1 and the second scan line GL2, the third scan line GL3 may be disposed to pass through the component area CA. The third scan line GL3 may be integrally formed without any part being disconnected or apart by the component area CA. Unlike the third scan line GL3, the fourth scan line GL4 may not have any portion overlapping the component area CA in a plan view.

Although FIG. 16 illustrates two first scan lines GL1, one second scan line GL2, one third scan line GL3, and one fourth scan line GL4, this is only for convenience of explanation, and three or more first scan lines GL1, two or more second scan lines GL2, two or more third scan lines GL3, and two or more third data lines GL4 may be disposed in the display area DA.

Second connection lines GNL may be disposed in the main display area MDA of the display area DA. The second connection line GNL may be disposed to bypass the component area CA. The second connection lines GNL may electrically connect the first sub-line and the second sub-line of each of the first scan lines GL1 to each other. For example, the second connection line GNL may include a second-1 connection line GNL1 and a second-2 connection line GNL2. The second-1 connection line GNL1 may electrically connect the first sub-line GL1-1a and the second sub-line GL1-1b of the first-1 scan line GL1-1 to each other. The second-2 connection line GNL2 may electrically connect the first sub-line GL1-2a and the second sub-line GL1-2b of the first-2 scan line GL1-2 to each other.

Although not illustrated, in an embodiment, the second-1 connection line GNL1 and the second-2 connection line GNL2 may be disposed on different layers from the first-1 scan line GL1-1 and the first-2 scan line GL1-2. The first-1 scan line GL1-1 and the first-2 scan line GL1-2 may not be connected to each other. The first-1 scan line GL1-1 and the first-2 scan line GL1-2 may be configured to receive different signals.

In an embodiment, the second-1 connection line GNL1 may be electrically connected to one end of the first sub-line GL1-1a of the first-1 scan line GL1-1 through a contact hole. The second-1 connection line GNL1 may be electrically connected to one end of the second sub-line GL1-1b of the first-1 scan line GL1-1 through a contact hole.

The same signal may be applied to the first sub-line GL1-1a and the second sub-line GL1-1b of the first-1 scan line GL1-1 through the second-1 connection line GNL1. Although the description is given based on the second-1 connection line GNL1, the same may also be applied to the second-2 connection line GNL2.

In an embodiment, the second-1 connection line GNL1 may be disposed adjacent to the component area CA and the second-2 connection line GNL2 may be disposed farther from the component area CA than the second-1 connection line GNL1. However, the disclosure is not necessarily limited thereto, and the shape in which the second-1 and second-2 connection lines GNL1 and GNL2 are disposed may vary.

The display apparatus according to the embodiment may be applied to various electronic devices. An electronic device according to an embodiment of the present disclosure may include the display apparatus (e.g., the display apparatus of FIG. 1) described above, and may further include modules or apparatuses having additional functions in addition to the display apparatus.

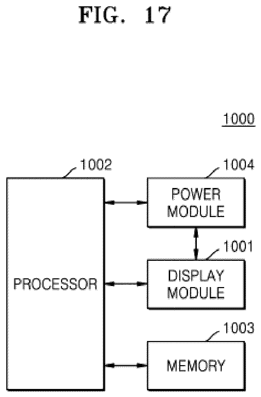

FIG. 17 is a block diagram illustrating an electronic device according to an embodiment.

Referring to FIG. 17, an electronic device 1000 according to an embodiment may include a display module 1001, a processor 1002, a memory 1003, and a power module 1004.

The processor 1002 may include at least one of a central processing unit (CPU), an application processor (AP), a graphic processing unit (GPU), a communication processor (CP), an image signal processor (ISP), and a controller.

The memory 1003 may store data information necessary for the operation of the processor 1002 or the display module 1001. When the processor 1002 executes an application stored in the memory 1003, an image data signal and/or an input control signal may be transmitted to the display module 1001, and the display module 1001 may process a signal received and output image information through a display screen.

The power module 1004 may include a power supply module such as a power adapter or a battery device, and a power conversion module that converts the power supplied by the power supply module to generate power necessary for the operation of the electronic device 1000.

At least one of the components of the electronic device 1000 described above may be included in the display apparatus according to the embodiments described above. In addition, a part among the individual modules functionally included in one module may be included in the display apparatus, and another part may be provided separately from the display apparatus. For example, the display apparatus may include the display module 1001, and the processor 1002, the memory 1003, and the power module 1004 may be provided in the form of other apparatuses within the electronic device 1000 except for the display apparatus.

In an embodiment, the display module 1001 included in the display apparatus may drive based on the image data signal and the input control signal received from the processor 1002.

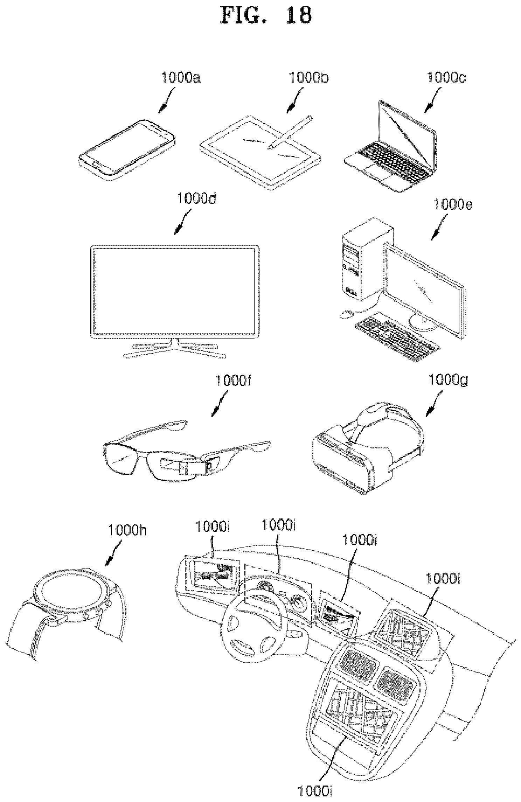

FIG. 18 is schematic diagrams illustrating electronic devices according to various embodiments.

Referring to FIG. 18, various electronic devices to which display apparatuses according to embodiments are applied may include not only image display electronic devices such as a smart phone 1000a, a tablet PC 1000b, a laptop 1000c, a TV 1000d, and a desk monitor 1000e, but also a wearable electronic device including display modules such as smart glasses 1000f, a head mounted display 1000g, and a smart watch 1000h, and a vehicle electronic device 1000i including a dashboard, a center fascia, and display modules such as a CID (Center Information Display) and a room mirror display disposed in the dashboard.

As described above, the electronic device (e.g., the display apparatus) according to the present embodiments may improve the light transmittance of the component area by minimizing the lines disposed in the component area. The scope of the disclosure is not limited by such an effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a substrate (100) comprising a first area (MDA) in which first sub-pixels (Pm) are disposed and a second area (CA) in which basic units (AU) are disposed, the basic units (AU) comprising transmission areas (TA) and sub-pixel groups (PG) comprising second sub-pixels (Pa);
first lines (DL1: DL1-1, DL1-2, DL1-3) extending in a first direction and electrically connected to the first sub-pixels (Pm), the first lines (DL1: DL1-1, DL1-2, DL1-3) each comprising a first sub-line (DL1-1a, DL1-2a, DL1-3a) and a second sub-line (DL1-1b, DL1-2b, DL1-3b) apart from each other with the second area (CA) therebetween;
first connection lines (DNL: DNL1, DNL2, DNL3) disposed in the first area (MDA) and each connecting the first sub-line (DL1-1a, DL1-2a, DL1-3a) and the second sub-line (DL1-1b, DL1-2b, DL1-3b) of each of the first lines (DL1: DL1-1, DL1-2, DL1-3) to each other; and
second lines (DL2) extending in the first direction and electrically connected to the second sub-pixels (Pa).

2. The display apparatus (1) of claim 1, wherein sub-pixel groups (PG) in each basic unit (AU) are apart from each other.

3. The display apparatus (1) of claim 1 or 2, wherein the sub-pixel groups (PG) and the transmission areas (TA) are alternately disposed in a same row along a second direction perpendicular to the first direction.

4. The display apparatus (1) of claim 3, wherein the second lines (DL2) are electrically connected to second sub-pixels (Pa) included in sub-pixel groups (PG) of a first row in the second area (CA) and first sub-pixels (Pm) disposed in a same column as the second sub-pixels (Pa) in the first row along the first direction.

5. The display apparatus (1) of claim 3, wherein a total number of second lines (DL2) passing through each basic unit (AU) among the second lines (DL2) is equal to a total number of second sub-pixels (Pa) included in one sub-pixel group (PG) and/or wherein the second lines passing through each basic unit (AU) are disposed sequentially or wherein each basic unit (AU) comprises a first sub-pixel group (PG1) and a second sub-pixel (Pa) group (PG2) disposed in different rows, and
each of the second lines passing through each basic unit (AU) is electrically connected to a second sub-pixel (Pa) included in the first sub-pixel group (PG1) and a second sub-pixel (Pa) included in the second sub-pixel group (PG2).

6. The display apparatus (1) of claims 1 to 5, wherein at least a portion of each of the first connection lines (DNL: DNL1, DNL2, DNL3) is disposed in a different layer from a corresponding first line among the first lines (DL1: DL1-1, DL1-2, DL1-3).

7. The display apparatus (1) of claim 6, wherein each of the first connection lines (DNL: DNL1, DNL2, DNL3) comprises a first portion (DNL1a) extending in the first direction, a second portion (DNL1b) connected to one end of the first portion (DNL1a) and extending in a direction crossing the first direction, and a third portion (DNL1c) connected to another end of the first portion (DNL1a) and extending in a direction crossing the first direction.

8. The display apparatus (1) of claim 7, wherein the first portion (DNL1a) of each of the first connection lines (DNL: DNL1, DNL2, DNL3) is disposed on a same layer as the corresponding first line among the first lines (DL1: DL1-1, DL1-2, DL1-3), and
the second portion (DNL1b) and the third portion (DNL1c) of each of the first connection lines (DNL: DNL1, DNL2, DNL3) are disposed in a different layer from the corresponding first line and are in contact with the corresponding first line through contact holes of at least one insulating layer.

9. The display apparatus (1) of claim 7, wherein each of the first sub-pixels (Pm) comprises a transistor (TFT) and a capacitor (Cst),
the transistor (TFT) comprises a semiconductor layer (A1), a gate electrode (G1) overlapping the semiconductor layer (A1), and an electrode layer (D1) electrically connected to the semiconductor layer (A1), and
the capacitor (Cst) comprises the gate electrode (G1) as a lower electrode (CE1) and an upper electrode (CE2) disposed to overlap the lower electrode (CE1).

10. The display apparatus (1) of claim 9, wherein the second portion (DNL1b) and the third portion (DNL1c) of each of the first connection lines (DNL1: DNL1, DNL2, DNL3) comprise a same material as a material of the electrode layer (D1).

11. The display apparatus (1) of claim 9, wherein each of the first sub-pixels (Pm) comprises a display element (OLEDm) electrically connected to the transistor (TFT), the display element comprising a sub-pixel electrode (221), an opposite electrode (223), and an intermediate layer between the sub-pixel electrode (221) and the opposite electrode (223), and
the display apparatus (1) further comprises a contact metal layer (CM) having a lower portion connected to the electrode layer (D1) and an upper portion connected to the sub-pixel electrode (221) and/or wherein the first portion (DNL1a) of each of the first connection lines (DNL: DNL1, DNL2, DNL3) comprises a same material as a material of the contact metal layer (CM).

12. The display apparatus (1) of claims 1 to 11, wherein the first lines (DL1: DL1-1, DL1-2, DL1-3) and the second lines (DL2) comprise data lines (DL).

13. The display apparatus (1) of claims 1 to 12, further comprising:
third lines (GL1, GL2) extending in a second direction perpendicular to the first direction and electrically connected to the first sub-pixels (Pm), the third lines each comprising a first sub-line (GL1-1a, GL1-2a, GL2a) and a second sub-line (GL1-1b, GL1-2b, GL2b) apart from each other with the second area (CA) therebetween; and
fourth lines (GL3) extending in the second direction and electrically connected to the second sub-pixels (Pa) and/or further comprising second connection lines (GNL: GNL1, GNL2) disposed in the first area (MDA) and each connecting the first sub-line (GL1-1a, GL1-2a) and the second sub-line (GL1-1b, GL1-2b) included in each of some of the third lines (GL1, GL2) to each other or wherein the third lines (GL1, GL2) and the fourth lines (GL3) comprise scan lines (GL).

14. The display apparatus (1) of claims 1 to 13, further comprising a component (40) overlapping the second area (CA) and/or wherein the component (40) comprises a camera or a sensor.

15. An electronic device (1000) comprising:
a display apparatus (1); and
a component (40) overlapping the display apparatus (1),
wherein the display apparatus (1) comprises:
a substrate (100) comprising a first area (MDA) in which first sub-pixels (Pm) are disposed and a second area in which basic units (AU) are disposed, the basic units (AU) comprising transmission areas (TA) and sub-pixel groups (PG) comprising second sub-pixels (Pa);
first lines (DL1: DL1-1, DL1-2, DL1-3) extending in a first direction and electrically connected to the first sub-pixels (Pm), the first lines (DL1: DL1-1, DL1-2, DL1-3) each comprising a first sub-line (DL1-1a, DL1-2a, DL1-3a) and a second sub-line (DL1-b, DL1-2b, DL1-3b) apart from each other with the second area (CA) therebetween;
first connection lines (DNL: DNL1, DNL2, DNL3) disposed in the first area (MDA) and each connecting the first sub-line (DL1-1a, DL1-2a, DL1-3a) and the second sub-line (DL1-1b, DL1-2b, DL1-3b) of each of the first lines (DL1: DL1-1, DL1-2, DL1-3) to each other; and
second lines (DL2) extending in the first direction and electrically connected to the second sub-pixels (Pa) and/or wherein sub-pixel groups (PG) in each basic unit (AU) are apart from each other, and the sub-pixel groups (PG) and the transmission areas (TA) are alternately disposed in a same row along a second direction perpendicular to the first direction or wherein a total number of second lines (DL2) passing through each basic unit (AU) among the second lines (DL2) is equal to a total number of second sub-pixels (Pa) included in one sub-pixel group (PG).
